# EUROPÄISCHE PATENTSCHRIFT

(11) **EP 2 394 178 B1**
(45) Veröffentlichungstag und Bekanntmachung des Hinweises auf die Patenterteilung: **24.10.2018**
(21) Anmeldenummer: 10720529.6
(22) Anmeldetag: 09.02.2010
(51) Int. Cl.: G01R 11/04, G01R 11/24, G01D 4/00, G01R 22/06

(54) **MODULARES, ERWEITERBARES UND EINEN ZUGANGSGESCHÜTZTEN BEREICH AUFWEISENDES MESSGERÄT**
MODULAR, EXPANDABLE MEASURING DEVICE COMPRISING AN ACCESS-PROTECTED AREA
APPAREIL DE MESURE MODULAIRE, EXTENSIBLE ET POSSÉDANT UNE ZONE À ACCÈS PROTÉGÉ

(30) Priorität: 09.02.2009 DE 102009008125
(43) Veröffentlichungstag der Anmeldung: 14.12.2011
(73) Patentinhaber: iAd Gesellschaft für Informatik, Automatisierung und Datenverarbeitung mbH, 90613 Grosshabersdorf (DE)
(72) Erfinder: HAMPEL, Hermann, 90613 Grosshabersdorf (DE); OSSIG, Andreas, 90427 Nürnberg (DE); YIN, Xianglong, 10587 Berlin (DE)
(74) Vertreter: Dreykorn-Lindner, Werner
(86) Internationale Anmeldenummer: PCT/EP2010/000843
(87) Internationale Veröffentlichungsnummer: WO 2010/091860

(56) Entgegenhaltungen:
- EP-A1- 0 961 122
- EP-A2- 0 494 428
- EP-A2- 1 593 978
- DE-A1-102004 040 916
- DE-U1- 20 001 278
- DE-U1-202004 019 570
- US-A- 4 571 691
- US-A- 5 523 559

## Beschreibung

Die Erfindung betrifft gemäß Patentanspruch 1 ein modulares, erweiterbares und einen zugangsgeschützten Bereich aufweisendes Messgerät, insbesondere Energiezähler mit Kommunikationsschnittstellen und Sabotageerkennung.

Heutzutage werden Verbrauchsdaten für verschiedene Versorgungsarten im Haushalt (Strom, Kaltwasser, Warmwasser, Wärme, Kälte, Gas, Öl oder vergleichbare Stoffe) an physikalisch unterschiedlichen Messstellen erfasst. Diese elementaren Versorgungsleistungen, die auch mit dem Begriff Multi Utility zusammengefasst werden, gleichen sich allerdings in folgenden Merkmalen:
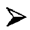 dem Bedürfnis, dass die gemessenen und geeichten Werte in der Rechnung nicht angezweifelt werden (Stichwort: Verbraucherschutz),
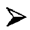 die Übertragung der lokal angezeigten Messwerte in Form von Zahlen an eine zentrale Stelle sowie die dortige Verarbeitung,
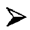 die Realisierung einer schnellen, zeit- und verbrauchsgerechten Rechnungslegung sowie die Überwachung durch ein Cash Management und
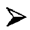 dem Bedürfnis, eine einheitliche Lösung für alle Versorgungsarten zu schaffen.

Bisherige technische Entwicklungen für Messgeräte sowie Systeme für ein kombiniertes Erfassen der Verbrauchsdaten weisen bestimmte typische Schwächen und Probleme, wie fehlende Durchgängigkeit oder Einzellösungen für bestimmte Segmente, auf. Versorgungsunternehmen, etwa Energieversorgungsunternehmen oder Wasserversorgungsunternehmen, erstellen in der Regel die Verbrauchsabrechnungen auf der Basis von Zählerstandsdaten von den Kunden zugeordneten Verbrauchszählern, welche meistens in der Nähe der Verbrauchsstellen installiert sind. Verbrauchszähler können beispielsweise Gaszähler, Wasserzähler, Stromzähler, Wärmezähler, Heizkostenverteiler etc. sein, wobei die Zählerstandsdaten jeweils für zurückliegende Verbrauchsperioden ein Maß für die an der Verbrauchsstelle verbrauchte Menge angeben. In der Regel erfolgt die Erfassung der Zählerstandsdaten bzw. die Zählerablesung für ein Haus, eine Wohnung oder ggf. eine einzelne Verbrauchsstelle mindestens einmal jährlich.

Stromzähler mit zwei und mehr Zählwerken, um unterschiedliche Tarife abrechnen zu können, wobei zwischen diesen Zählwerken durch eingebaute oder externe Rundsteuerempfänger (die durch zentrale Rundsteueranlagen im Energieversorgungsunternehmen gesteuert werden) oder durch Tarifschaltuhren entsprechend umgeschaltet wird, sind seit vielen Jahren gebräuchlich. Die seit einigen Jahren neu entwickelten elektronischen Energiezähler enthalten keine mechanischen Elemente. Die Erfassung des Stromes erfolgt beispielsweise durch Stromwandler mit einem weichmagnetischen Ringkern (beziehungsweise Strommesssystemen mit Rogowskispulen) mittels Nebenschlusswiderstand (Shunt) oder Hallelementen. Die Berechnung der Energie erfolgt mit einer elektronischen Schaltung und das Ergebnis wird einer alphanumerischen Anzeige (meist Flüssigkristallanzeige, LCD) zugeführt. Bei Sondervertragskunden (Industrie) sind weitere Zählwerke, auch für die Leistungserfassung, gebräuchlich. Jedoch wird in der Praxis hier nach und nach auf elektronische Zähler mit einer Aufzeichnung des Lastgangs umgestellt. Somit kann die Tarifierung ohne Eingriff in den Zähler verändert werden und es werden im Zähler keine getrennten Zählwerke mehr benötigt.

Manche elektronischen Zähler können über Datenschnittstellen per Fernabfrage vom Energieversorgungsunternehmen und der Gebäudeautomation ausgelesen werden. Als Datenschnittstellen sind in der Praxis Infrarot, S0-Schnittstelle, M-Bus, Potentialfreier Kontakt u.a. verbunden mit GSM-, PSTN-Modems oder PLC-Modul gebräuchlich. Derzeit finden in der Bundesrepublik Deutschland (ab April 2006) auch Feldversuche mit ständigen Verbindungen über Internet (DSL) statt. In den USA wurden elektronische Haushaltszähler mit einem integrierten Relais entwickelt, die dem Energieversorger neben der Fernauslesbarkeit das ferngesteuerte Abschalten ermöglichen, beispielsweise bei ausstehender Zahlung der Rechnung. In Deutschland werden intelligente Zähler zunehmend im Rahmen von Pilotprojekten zur Einführung der Smart-Metering-Technologie eingesetzt. Die Impulsausgänge (S0) liefern in der Regel Verbrauchsdatensignale, welche zwischen 2000 bis 5000 Impulsen pro kWh umfassen. Dieser Wert muss dann abhängig vom Zähler mit einem festen Faktor von zum Beispiel 30 oder 50 multipliziert werden, um den kumulierten Messwert zu bekommen.

Stromzähler, die im geschäftlichen Verkehr eingesetzt werden, unterliegen in der Bundesrepublik Deutschland der Eichpflicht. Nach Ablauf der Eichgültigkeitsdauer (16 Jahre beziehungsweise 8 Jahre bei elektronischen Zählern, 12 Jahre für mechanische Messwandlerzähler mit Induktionswerk, d.h. mit Läuferscheibe) muss das Messgerät ausgetauscht oder die Eichgültigkeit verlängert werden.

Beispielsweise ist aus der WO 2006/048143 A1 eine Vorrichtung zur zuverlässigen und energiesparenden Erkennung von Gehäusemanipulationen an Verbrauchszählern ohne mechanisch betätigbaren Taster oder Magnetschalter oder Lichtschranke bekannt. Im Einzelnen umfasst diese Vorrichtung ein eine Auswerteelektronik aufnehmendes erstes Gehäuseteil sowie ein vom ersten Gehäuseteil lösbares zweites Gehäuseteil und das erste Gehäuseteil ist gegen unberechtigtes Entfernen des zweiten Gehäuseteiles gesichert. Im ersten Gehäuseteil ist hierzu ein aus einer Spule und einem Kondensator bestehender elektrischer Schwingkreis vorgesehen, dessen Spule durch ein im zweiten Gehäuseteil befindliches metallisches Material bei einer Änderung des Abstandes zwischen der Spule und dem metallischen Material ein Signal erzeugt und das Signal der im ersten Gehäuseteil befindlichen nachgeschalteten Auswerteelektronik zuführt und zur weiteren Verarbeitung bereitstellt. Für die Erkennung des Entfernens des zweiten Gehäuseteils vom ersten Gehäuseteil, die eine Änderung der Güte der Spule des Schwingkreises bedingt, wird die Stärke der Bedämpfung des Schwingkreises und damit die Dauer der Impulsantwort der elektrischen Schaltung herabgesetzt. Der elektrische Schwingkreis der erfindungsgemäßen Vorrichtung ist vorzugsweise als Annäherungsschalter mit einem geringen Strombedarf ausgeführt. Zur Anregung des Schwingkreises genügt ein sehr kurzer Spannungsimpuls mit sehr niedriger Energie. Erfolgt die Anregung gleichzeitig mit vergleichsweise niedriger Periodizität, beispielsweise alle zehn Sekunden, ergibt sich ein sehr niedriger mittlerer Leistungsbedarf der erfindungsgemäßen Überwachungsschaltung, der auch über sehr lange Zeiträume einen Betrieb aus primären oder sekundären Batterien oder hochkapazitiven Kondensatoren ermöglicht. Die Dauer der Impulsantwort ist von der Stärke der Bedämpfung des Schwingkreises direkt abhängig und wird mit Hilfe einer Mikroprozessorschaltung ausgewertet.

Ein ähnlicher Schutz gegen unberechtigte Manipulation ist aus der WO 2004/021020 A1 bekannt, welcher darin besteht, dass bei einem Gehäuse für einen Zähler mittels einer plombierbaren Gehäuseabdeckung, die die Zähleranschlüsse abdeckt, mindestens eine weitere Zählervorrichtung abgedeckt ist, die mittels einer zweiten Plombierung gegen unberechtigten Zugriff schützbar ist. Die Plombierung der weiteren zu schützenden Zählervorrichtung ist so gestaltet, dass sie bei klemmendeckelfreiem Zustand frei zugänglich ist und somit visuell einfach und schnell überprüfbar ist. Hierzu weist das Zählergehäuse mindestens eine Plombieröse auf, mit der die Plombierbohrung der Zusatzabdeckung zusammenwirkt, wobei ein Plombierstift durch die mindestens eine Plombieröse und die Plombierbohrung als Bindeglied funktioniert. Dabei ist besonders vorteilhaft, wenn die mindestens eine Plombieröse von der Plombierbohrung beabstandet angeordnet ist, so dass eine Sollbruchstelle des Plombierstiftes, insbesondere ein transparenter Plombierstift, zwischen ihnen sichtbar ist.

Weiterhin sind Adapter oder Zählertragplatten für elektronische Haushaltszähler (kurz auch eHZ genannt) bekannt, welche an ihrer Befestigungsseite nach unten herausragende Kontaktfahnen besitzen, die mit geeigneten Kontakteinrichtungen in elektrisch leitende Verbindung gebracht werden. Damit kann der Austausch eines Stromzählers oder der neue Einbau einfach bewerkstelligt werden, ohne dass beim Ausbau beziehungsweise Austausch der Strom zu den Verbrauchern unterbrochen wird. In der Regel weisen diese Plattformen eine Auslieferungsposition, eine Montageposition und eine Betriebsposition auf. Verbraucher könnten zur Manipulation nun versuchen zumindest zeitweise die Plattform aus der Betriebsposition in die Montageposition zu bringen, so dass dann der von ihnen verbrauchte Strom nicht durch den Zähler erfasst würde. Ebenfalls könnten Verbraucher, bei denen der Stromzähler entfernt und die Plattform in den Auslieferungszustand versetzt wurde, versuchen, die Plattform aus der Auslieferungsstellung in die Montageposition zu bringen, um so unberechtigterweise Strom aus dem Versorgungsnetz entnehmen zu können, ohne ihn zahlen zu müssen. Um eine unbefugte Stromentnahme wirksam zu verhindern, auch wenn die Plombiereinrichtung zwischen Zähler und Plattform entfernt wurde, ist aus der DE 10 2006 055 322 A1 ein Stromzählersystem mit eine Unterbrechungsvorrichtung und eine Aufnahmeplattform mit einer Verschiebeerkennungsvorrichtung bekannt, wobei die Unterbrechungsvorrichtung so mit der Verschiebeerkennungsvorrichtung zusammenwirkt, dass bei Verschiebung des Zählers auf der Plattform aus der Betriebsposition in die Montageposition die Stromzufuhr zum Zähler durch die Unterbrechungsvorrichtung bleibend unterbrochen wird. Beispielsweise umfasst die Unterbrechungsvorrichtung einen Trennschalter mit einem Schaltgriff zum manuellen Ein- und Ausschalten des Trennschalters sowie mit einer Verklinkungsstelle, der so eingerichtet ist, dass bei entklinkter Verklinkungsstelle der Trennschalter (Sicherungshauptschalter, Leistungsschutzschalter) geöffnet ist und sich durch den Schaltgriff nicht mehr schließen lässt. Alternativ umfasst die Unterbrechungsvorrichtung eine Zwangsauslösevorrichtung (Arbeitsstromauslöser, Stellantrieb), die durch die Verschiebeerkennungsvorrichtung aus einer Einschalt- in eine Ausschaltstellung verbringbar ist, und die mit der Verklinkungsstelle des Trennschalters so zusammenwirkt, dass diese in der Ausschaltstellung der Zwangsauslösevorrichtung entklinkt ist. Die Unterbrechung der Stromzufuhr kann nur mithilfe spezieller Rücksetzmittel aufgehoben werden. Weiterhin umfasst die Verschiebeerkennungsvorrichtung einen Endschalter oder eine Lichtschranke, welche so angeordnet bzw. betätigt (Befestigungskrallen des Stromzählers) sind, dass diese ein Verschiebeerkennungssignal an die Unterbrechungsvorrichtung abgeben, wenn der Stromzähler aus der Betriebsposition in die Montageposition verbracht ist. Weiterhin umfasst die Verschiebeerkennungsvorrichtung eine Verzögerungsschaltung (Verzögerung des Verschiebeerkennungssignals um einige Minuten), so dass der Monteur genügend Zeit hat, um den Stromzähler zu wechseln, ohne dass der Sicherungshauptschalter die Stromzufuhr unterbricht. Schließlich ist über eine Fernwirkeinrichtung das Verschiebeerkennungssignal an einen entfernten Ort und von dem entfernten Ort ein Unterbrechungssignal an die Unterbrechungsvorrichtung übertragbar, wobei als Fernwirkeinrichtung beispielsweise eine Modemverbindung über die Telefonleitung benutzt werden kann.

Um eine eindeutige, automatische und fehlerfreie Zuordnung des jeweiligen Erfassungs- oder Zählortes bei Verwendung von Zählertragplatten (Montageelement, Montageeinrichtung) und des austauschbar darauf befestigten Erfassungs- und Zählgerätes zu ermöglichen, ist aus der DE 10 2007 021 138 A1 ein Erfassungsgerät mit wenigstens einer elektronischen Sicherung oder Plombierung bekannt. Im Einzelnen weist das Montageelement wenigstens eine Informationseinheit mit einem nicht flüchtigen Speicher zur Speicherung von das Montageelement und/oder den Erfassungsort identifizierenden Informationen und/oder Daten auf und das Erfassungsgerät besitzt wenigstens eine Leseeinheit zum Auslesen dieser Daten. Die Informationseinheit ist bevorzugt von einem RFID-TAG gebildet, welche dabei so ausgeführt ist, dass bei einem Öffnen des zugangsgeschützten Raumes zwangsläufig ein Zerstören der Plombierung, d.h. ein Zerstören eines wesentliches Funktionselement dieser Informationseinheit erfolgt. Dieser Zustand wird dann von der Leseeinheit erfasst, im Erfassungsgerät abgespeichert und/oder über eine Datenfernübertragung an eine zentrale Überwachungs- und/oder Datenerfassungseinheit übertragen. Erfassungsgeräte sind u.a. Sensoren oder Überwachungsgeräte eines Überwachungssystems, insbesondere aber Zählgeräte und dabei speziell Verbrauchszähler, wobei im Inneren des Gehäuses des Zählgeräts wenigstens ein zugangsgeschützter Raum ausgebildet ist. Das Gehäuse kann von berechtigten Personen geöffnet werden und ist zweiteilig bestehend aus miteinander verbundenen Gehäuseteilen ausgeführt. Zum Plombieren bzw. Sichern des Gehäuseinnenraumes ist an der Außenseite des Gehäuses wenigstens eine elektronische Plombierung so vorgesehen, dass diese Plombierung den Übergang zwischen den beiden Gehäuseteilen überlappt. Das Entfernen der Sicherung vom Gehäuse und/oder das Öffnen des Gehäuses ist nicht ohne eine Zerstörung eines wesentlichen Funktionselementes der elektronischen Sicherung, beispielsweise nicht ohne eine Zerstörung der Antennenstruktur und/oder des integrierten Schaltkreises des RFID-TAGs möglich, welche wiederum unverzüglich an die Datenerfassungs- und/oder Überwachungszentrale gemeldet werden kann. Der RFID-TAG kann in einer Wandung des Montageelementes untergebracht - beispielsweise eingeschlossen oder eingegossen - sein bzw. an oder in einer Wandung des Gehäuses untergebracht sein.

Um die Anzahl der Zählervarianten zu reduzieren, ist aus der DE 20 2004 002 731 U1 ein Stromzähleradapter mit mindestens einem integrierten Strom- und/oder Spannungswandler bekannt, wobei jeder Strom- und/oder Spannungswandler an einer Wandlerseite an einem Messwandler eines Stromlieferanschlusses eines versorgenden Netzbetreibers und an einer anderen Wandlerseite an einem Stromzähler anschließbar ausgebildet ist. Der Sekundärstrom des Stromwandlers (zweiter Wandler) fließt in den Stromzähler bzw. in einem Stromsensor des Stromzählers (dieser Strom kann auch als Tertiärstrom bezeichnet werden), wobei der Tertiärstrom durch ein Windungsverhältnis des Stromwandlers vorzugsweise so bemessen ist, dass der Primärstrom des Messwandlers gleich dem Tertiärstrom ist. Dadurch kann ein elektronischer Haushaltszähler eingesetzt werden, dessen Funktionsumfang aber einem klassischen, direkt angeschlossenen Zähler für Industriekunden entspricht. Somit kann in vorteilhafter Weise ein Zähler, insbesondere ein Lastgangzähler eingesetzt werden, der eigentlich zum direkten Anschluss an dem Strompfad eines Stromlieferanschlusses ausgebildet bzw. nach eHZ-Technik spezifiziert ist. Bei einem Zählerwechsel kann der auszutauschende Zähler wie bei einer Steckdose entfernt werden, wobei ein neuer Zähler in einfacher Weise eingesteckt werden kann.

Weiterhin ist aus der DE 10 2005 061 216 A1 ein Verbrauchszähler, insbesondere ein Verbrauchserfassungsgerät für Wärme, Wasser oder Gas bekannt, welches ein Grundgerät und ein separates Modul zur Übertragung von Daten zu und von dem Grundgerät umfasst. Im Einzelnen kann der individuellen Gerätenummer des Grundgeräts ein vom Benutzer frei wählbarer Aliasnamen zugeordnet und unter diesem Aliasnamen können alle relevanten Daten von Grundgerät und Modul ausgelesen werden. Das bedeutet, dass auch nach Austausch des Grundgerätes, beispielsweise wegen Ablaufs der Eichdauer, in der Verbrauchsabrechnung keinerlei Änderungen vorgenommen werden müssen. Grundgerät und Modul verwenden dabei ein Datenaustauschprotokoll, welches den Abgleich von Namen und Daten vollautomatisch durchführt und wobei die Datenübertragung zwischen Modul und Grundgerät bidirektional ist. Der gleiche gilt, wenn wegen gestiegener Anforderungen das vorhandene Modul gegen ein erweitertes Modul ausgewechselt wird. Weiterhin besitzt das Modul einen Anschluss für einen externen Bus, insbesondere ein M-Bus, welcher drahtlos oder auch drahtgebunden angeschlossen sein kann. Dabei ist die Schnittstelle des Moduls zum Grundgerät identisch mit der Schnittstelle für den externen Anschluss, wodurch es möglich ist, das Modul "durchsichtig" zu schalten, d.h. eine externe Einheit kann durch das Modul hindurch direkt auf das Grundgerät zugreifen, beispielsweise im Fall einer Wartung, einer Neuprogrammierung oder dergleichen. Für den Fall eines Wärmeverbrauchszählers errechnet eine Recheneinheit aus den von Fühlern zugeführten Messwerten den Wärmeenergieverbrauch, wobei in einem Speicher hinterlegte Korrekturwerte für eine exakte Energieanzeige am Grundgerät sorgen. Gespeist wird die Rechen- und Speichereinheit durch eine Batterie, deren Kapazität so groß sein muss, dass sie das Grundgerät während der gesamten Eichdauer von fünf Jahren versorgen kann. Das Grundgerät enthält alle Komponenten, die für die Eichfähigkeit erforderlich sind und eine Schnittstelle für Daten und gegebenenfalls Energie, beispielsweise in Form einer Induktionsspule oder auch kapazitiv bzw. drahtgebunden, gegebenenfalls auch einen Interrupt-Generator.

Weitere Elektrizitätszähler sind aus DE202004019570, DE20001278, EP494428, DE102004040916 und US5523559 bekannt.

Weiterhin ist aus der US 2006/0091877 A1 ein Elektrizitätszähler mit einem Mikroprozessorkern bekannt, bei dem unter anderem die Funktion der Sabotageerkennung ist. Die Sabotageerkennung erfolgt auf der Grundlage eines Sabotagesensors, im einfachsten Fall ein Schalter (Öffnungsdetektor). Demzufolge sind beim Gegenstand der US 2006/0091877 A1 immer zusätzlich bestimmte Mittel, nämlich Sensor, Schalter, Impedanzdetektionsschaltung, etc. nötig, wobei im zuletzt genannten Fall ein zusätzlich Schutz vor transiente Überspannungsspitzen (mittels Widerstände und Dioden) erforderlich ist. Als externe Module sind außerdem nur ein Servicemodul, z.B. tragbares Lesegerät mit drahtloser Anbindung an den Elektrizitätszähler, ein (optionaler) externer (Erweiterungs-)Speicher und ein Relais zum Schalten eines externen Gerätes genannt
Schließlich ist aus der US-A 4, 571,691 ein Zähler zur Messung der Wirkenergie bekannt, bei dem die Sabotagedetektion durch Überwachung einer separaten Übertragungsstrecke erfolgt, die beim Lösen der Schrauben oder beim Entfernen oder Bewegen eines Befestigungsringes (was bspw. zum Entfernen des Gehäusedeckels nötig ist) irreparabel unterbrochen wird. Nachteil hierbei ist, dass erstens eine separate Übertragungsstrecke (z.B. optische Faser) benötigt wird sowie zweitens eine spezielle Anbringung dieser Strecke - und damit erhöhter Fertigungsaufwand - erforderlich ist.

Vom Stand der Technik her gesehen sind also verschiedene Systeme zum Schutz gegen unberechtigte Manipulation durch Endverbraucher/-kunden, insbesondere mittels plombierbarer Gehäuseabdeckung (beispielsweise WO 2004/021020 A1) oder elektronischer Plombierung (elektrischer Schwingkreis gemäß WO 2006/048143 A1 oder RFID gemäß DE 10 2007 021 138 A1), bekannt. In der Regel sind die Geräte für das Energieversorgungsunternehmen derart ausgestaltet, dass Verbrauchsdaten vom Ort des Entstehens (also beim Endkunden, z.B. Heimbereich, aber auch Industrie oder Kommunen), möglichst einfach und kostengünstig erfasst (Ressourcenzähler z.B. Strom-, Wasserzähler) und ebenfalls möglichst einfach und kostengünstig an eine Zentrale zu übertragen werden (Kommunikationsverfahren), wo diese in automatisierten Abrechnungen für die oben genannten Endkunden verarbeitet werden können. Der Anwender ist immer der Messstellenbetreiber bzw. Messdienstleister, welcher die Ressourcenzähler beschafft, beim Kunden einbaut, wartet, abliest; das Gleiche gilt für die Kommunikationseinrichtungen. Wenig Beachtung fand jedoch die Entwicklung eines solchen (universellen) Messgeräts/Zählers, bei dem mit geringem zusätzlichem Aufwand eine Zählervariante geschaffen werden kann. Deshalb fehlt in der Praxis ein solches Messgerät/Zähler, welches/r unabhängig von anderen technischen Gegebenheiten universell einsetzbar ist und welches/r auf einfache Art und Weise erweiterbar/umrüstbar ist und welches/r mindestens einen zugangsgeschützten Bereich/Raum im Gehäuse aufweist. Besonders bedeutsam ist dies, weil die Messgeräte herstellende Industrie als äußerst fortschrittliche, entwicklungsfreudige Industrie anzusehen ist, die schnell Verbesserungen und Vereinfachungen aufgreift und in die Tat umsetzt.

Der Erfindung liegt die Aufgabe zugrunde, ein einen zugangsgeschützten Bereich aufweisendes Messgerät derart auszugestalten, dass dieses auf einfache Art und Weise erweiterbar oder umrüstbar ist, ohne hierdurch die Sicherung, insbesondere Schutz gegen unberechtigte Manipulation zu verringern.

Diese Aufgabe wird, gemäß Patentanspruch 1, durch ein Messgerät insbesondere Energiezähler in Modulbauweise, welcher aufweist:
- ein zweiteiliges Gehäuse mit einer lösbaren Verbindung zum Zusammenhalt der Gehäuseteile,
- mindestens ein in einem geschützten Bereich angeordnetes internes Modul,
- mindestens ein außerhalb des geschützten Bereichs angeordnetes externes Modul und
- mindestens eine im internen Modul und/oder externen Modul angeordnete optische Schnittstelle, welche zur Kommunikation zwischen dem internen Modul und dem externen Modul einschließlich Erkennung der Öffnung des geschützten Bereichs dient,
gelöst.

Das erfindungsgemäße Messgerät weist im Vergleich zum Stand der Technik den Vorteil einfacher Implementierung neuer Funktionen und niedrigerer Kosten für Erweiterung und Umrüstung auf. Hierzu besteht das erfindungsgemäße System aus mehreren Modulen, die teils optional, d.h. nachrüstbar sind. Dabei kann unterschieden werden zwischen internen und externen Modulen. Interne Module sind solche, die üblicherweise im verplombten Teil des Messgeräts enthalten sind und die daher für den Kunden nicht zugänglich oder austauschbar sind (nur vom Hersteller/Vertreiber). Externe Module sind solche, die nicht im verplombten Teil des Messgeräts enthalten sind und die daher für den Kunden zugänglich und austauschbar sind. Für den Anwendungsfall Zähler, insbesondere Energiezähler besteht für den Kunden hier die Möglichkeit, weitere Module nachzurüsten (Kunde ist in diesem Zusammenhang nicht der Endverbraucher, sondern der Käufer der Zähler wie EVUs, Stadtwerke etc.), wodurch insgesamt gesehen eine kostengünstige, kompakte, flexible, installationsfreundliche Lösung erhalten wird. Der erfindungsgemäße Zähler kann nach jeweiligem Bedarf modular zusammengebaut werden bzw. Standardvarianten können vorgefertigt werden; bei geändertem Bedarf des Kunden können weitere Funktionalitäten einfach nachgerüstet werden. Dies kann dann ohne Austausch des Zählers erfolgen, sondern durch Austausch von Modulen oder einfache Anbringung neuer Module, bei gleichzeitiger Verriegelung der optischen Übertragungsstrecke (und damit Möglichkeit auch der Protokollierung des Eingriffs des Servicepersonals) und somit Schutz vor Manipulationen. Weiterhin ist von Vorteil, dass die optischen Übertragungsstrecke/n nicht, wie beim Stand der Technik zerstört werden, sondern durch Schließen des/der Deckels/Deckel wieder geschlossen werden (auch im Reparaturfall bzw. Nachrüstfall mit Umstecken eines Verbindungskabels (Lichtleiter) zwischen den internem Modulen oder Ersetzen des Reflektors durch Lichtleiter und Sende-/Empfangsdiode).

Bei einer bevorzugten Ausgestaltung der Erfindung sind, gemäß Patentanspruch 2, im geschützten Bereich als interne Module ein Zählermodul und ein Klemmenmodul angeordnet, wobei das Klemmenmodul einen Anschlussblock zum Netzanschluss, zum Anschluss der Stromversorgung der internen und/oder externen Module und zum Anschluss mindestens eines Shunt, eines Messwandlers oder einer Rogowski-Spule aufweist.

Diese Ausgestaltung der Erfindung weist den Vorteil auf, dass der im separaten Klemmenmodul enthaltene Anschlussblock gleichzeitig bis zu 4 Funktionen, nämlich
▪ Netzanschluss
▪ Kontaktierung für Optionsmodul
▪ Shunt-Anschluss oder Anschluss für Messwandler oder Rogowski-Spule
▪ Adaptierung von PLC-Board (in Klemmen integriert), d.h. Schnittstelle für PLC-Board zum Netz
erfüllen kann.

In Weiterbildung der Erfindung ist, gemäß Patentanspruch 3, im geschützten Bereich als internes Modul ein Options-/Nachrüstmodul zur Kommunikationsanbindung des Zählers zur bidirektionalen Datenkommunikation, insbesondere Fernauslesung verschlüsselter Daten, über das Klemmenmodul in das Stromversorgungsnetz zu einer Zentrale vorgesehen.

Diese Weiterbildung der Erfindung weist den Vorteil auf, dass durch die kombinierte Datenübertragung über drahtgebundene und optische Strecken das Nachrüstmodul eine rückwirkungsfreie Kommunikationsanbindung des Zählers (z.B. PLC-Modul (1 oder 3-phasig) für WAN-Schnittstelle, auch M-Bus, ZigBee, GPRS, etc.) bzw. über die optische Schnittstelle zum Zählermodul (zur Übergabe von Messwerten, Parametrierung des Zählers, etc.) ermöglicht. Weiterhin erlaubt das Optionsmodul vielfältige Steuerungsmöglichkeiten, insbesondere interne und/oder externe Relais sowie externe Optionsmodule, wobei hierzu eine uni- oder bidirektionale Kommunikation verwendet wird. Schließlich kann das Options-/Nachrüstmodul ein AES-und-Signatur-Modul (Advanced Encryption Standard) zur Verschlüsselung der (Fern)-Kommunikation enthalten bzw. in Verbindung mit einer CPU (Mikrocomputer) mit ECC im Zählermodul für die Signierung/Verschlüsselung der (internen) Kommunikation).

Bei einer bevorzugten Ausgestaltung der Erfindung ist, gemäß Patentanspruch 9, im als Gehäusehaube ausgestalteten Klemmendeckel ein Klemmen- und Erweiterungsmodul als externes Options-/Nachrüstmodul mit optischer Anbindung an das Zähler- oder ein internes Options-/Nachrüstmodul oder ein Reflektor angeordnet.

Diese Ausgestaltung der Erfindung weist den Vorteil auf, dass eine ohnehin vorhandene optische Kommunikationsstrecke, die zur Anbindung eines/mehrerer externer optionaler Module dient, für die Sabotageüberwachung genutzt wird. Ist kein entsprechendes (Nachrüst-) Modul zur Kommunikation vorhanden, kann zur Sabotageüberwachung die Kommunikation über einen Reflektor (Vorteil gegenüber dem Stand der Technik. günstig, einfach anzubringen) geführt werden.

Weitere Vorteile und Einzelheiten lassen sich der nachfolgenden Beschreibung von bevorzugten Ausführungsformen der Erfindung unter Bezugnahme auf die Zeichnung entnehmen. In der Zeichnung zeigt:
- **FIG. 1**: das Blockschaltbild eines Messgeräts in der Ausgestaltung als Energiezähler mit mehreren, auch optionalen Modulen,
- **FIG. 2**: das Ausführungsbeispiel "Standard-Meter" bestehend aus Zählermodul und Standardklemmenmodul,
- **FIG. 3**: eine Ausgestaltung des Energiezählers nach **FIG. 1** in der Ausführungsform "Standard-Meter" mit zusätzlichem internen Optionsmodul und externem Klemmen- und Erweiterungsmodul,
- **FIG. 4**: eine Ausgestaltung des Energiezählers nach **FIG. 1** in der Ausführungsform "Standard-Meter" mit zusätzlichem internen Optionsmodul,
- **FIG. 5**: eine weitere Ausgestaltung des Energiezählers nach **FIG. 1** mit beliebigem Schnittstellenmodul,
- **FIG. 6**: in Seitenansicht das Zähler- und Klemmenmodul im Detail,
- **FIG. 7**: in Draufsicht das Detail von Zähler- und Klemmenmodul nach **FIG. 6** und
- **FIG. 8**: in Seitenansicht eine schematische Skizze einer Ausführung des Zählergehäuses.

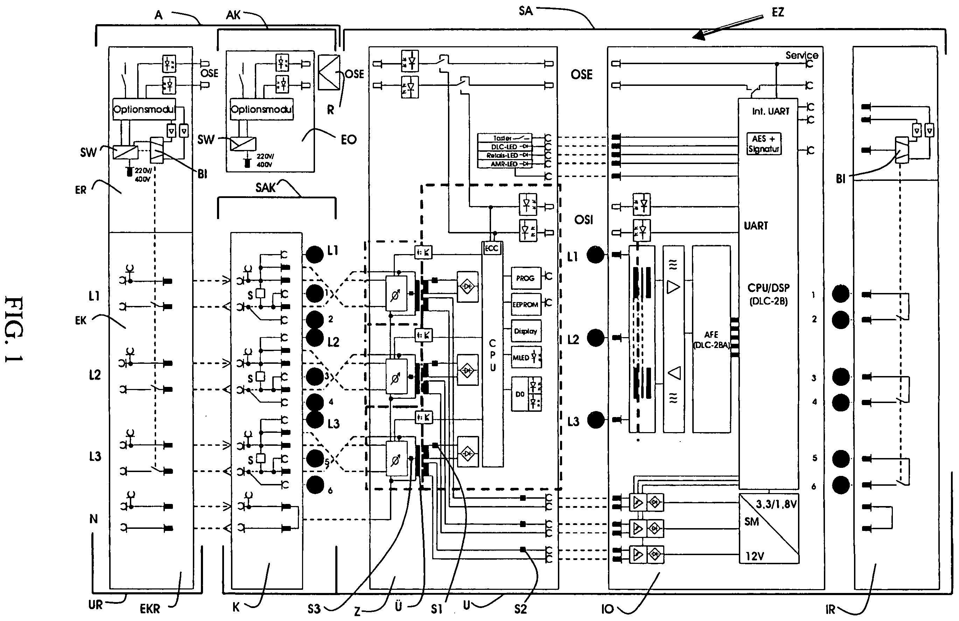

**FIG. 1** zeigt das Blockschaltbild einer bevorzugten Ausführungsform des erfindungsgemäßen Messgeräts EZ, dessen Bedienung für den Benutzer sehr einfach und ohne EDV-Kenntnisse durchführbar ist. Auch wenn nachfolgend die Ausgestaltung der erfindungsgemäßen Lösung für einen Energiezähler EZ mit den Hauptfunktionalitäten der Messwerterfassung und einer Kommunikation nach außen beschrieben ist, so ist das erfindungsgemäße Konzept auch bei anderen Geräten mit entsprechenden Schnittstellen, beispielsweise zur Messung der Energieeinspeisung von Solaranlagen in das Energieversorgungsnetz, möglich. Dies ist darauf zurückzuführen, dass das erfindungsgemäße Konzept auf Modulbauweise und entsprechender Konfigurierbarkeit aufbaut und die einfache Anpassung an die jeweiligen Gegebenheiten und Einbindung ohne Änderung der Erfindung bzw. des Grundkonzepts erlaubt.

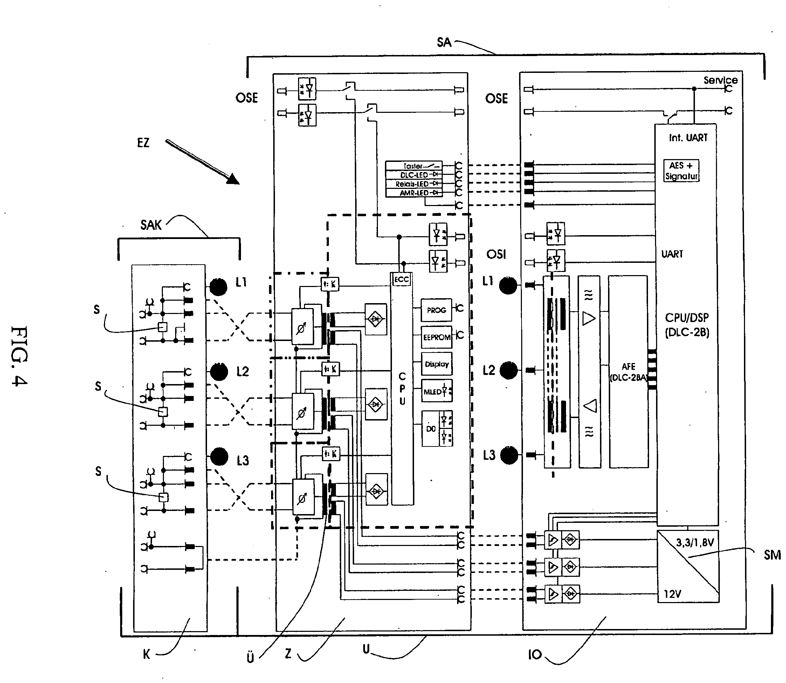

Das erfindungsgemäße System, wie in **FIG. 1** bis **FIG. 5** dargestellt, besteht aus mehreren Modulen, die teils optional, d.h. nachrüstbar sind. Dabei kann unterschieden werden zwischen internen Modulen, insbesondere Zählermodul Z, Klemmenmodul K, (internes) Relaismodul IR und (internes) Options-/Nachrüstmodul IO sowie externen Modulen, insbesondere Klemmen- und Erweiterungsmodul EO sowie Klemmen- und Relaismodul EKR. Bei der in **FIG. 1** dargestellten Gesamtstruktur des erfindungsgemäßen Zählers EZ mit allen (auch optionalen/nachrüstbaren) Modulen ist das Klemmenmodul K nicht als Standardklemmenmodul dargestellt, sondern bereits mit dem Anschluss für ein internes Relaismodul IR als optionale Erweiterung. In einer bevorzugten Ausgestaltung des Systems enthält der Zähler EZ alle aufgeführten Module, abgesehen von dem internen IR Relaismodul oder dem Klemmen- und Relaismodul EKR, da beide nicht sinnvoll gemeinsam in einem Gerät bestückt sind.

Das Zählermodul Z dient dabei zur Ermittlung der Zählerwerte (Energiemesswerte), die er über optische Schnittstellen OSI, OSE an das interne und externe Optionsmodul IO, EO weitergibt.

Das interne Nachrüstmodul IO dient dabei vorzugsweise zur Kommunikationsanbindung des Zählers, z.B. außerhalb des Hausanschlusses, wie z.B. zur Übertragung von Zählerdaten vom Zähler zu einer Zentrale bzw. zu einem Datenkollektor (Zählerfernauslesung für Messdienstleister), vorzugsweise via PLC, insbesondere DLC-Komponenten der Anmelderin (siehe **FIG. 1** AFE (DLC-2BA) und CPU/DSP (DLC-2B)).

Das Options-/Nachrüstmodul im Klemmen- und Erweiterungsmodul EO ist bspw. als Funk-Modul ausgeführt (z.B. Wireless M-Bus, ZigBee) zur Anbindung weiterer Zähler im Haus über Funk (z.B. Heizkostenverteiler, Wasserzähler), als PLC-Modul zur hausinternen Kommunikation über das Stromnetz oder auch als Schnittstelle für Geräte anderer Applikationen (z.B. Display, Kundenschnittstelle, serielle Schnittstelle, USB, Ethernet). Hierdurch kann ein Datenerfassungs- und Steuerungssystem mit Datenübertragung über Funkstrecken und elektrischen Energieverteilnetzen - wie dies Gegenstand der Deutschen Patentanmeldung 10 2006 020 030.6-35 der Anmelderin ist - eingebunden werden. Somit kann sie auch zur Überprüfung der Zählerdaten bzw. Rechnungsdaten des EVU dienen.

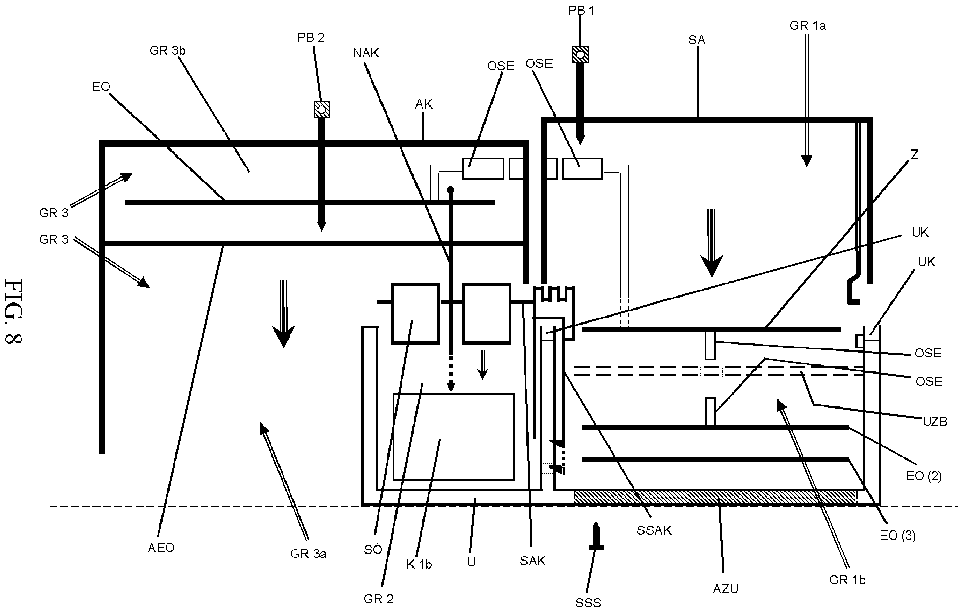

Die internen Module sind im verplombten Teil (nachfolgend auch als geschützter Bereich/Raum GR1, GR1a bezeichnet, siehe **FIG. 8**) des Zählers EZ enthalten und daher für den Kunden nicht zugänglich oder austauschbar (nur vom Hersteller/ Vertreiber), während die externen Module im nicht verplombten Teil des Zählers EZ enthalten sind und daher für den Kunden die Möglichkeit bieten, weitere Module nachzurüsten.

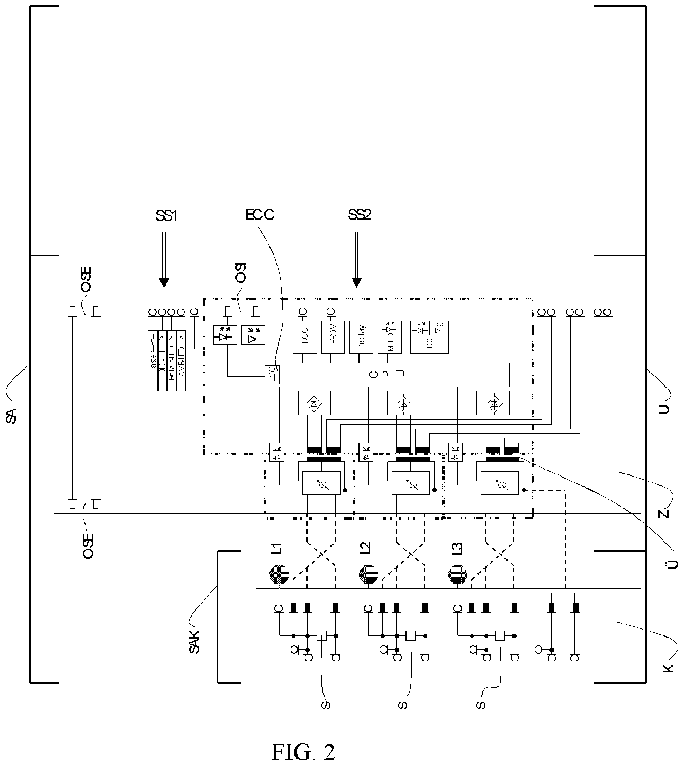

Das Gehäuse ist, wie insbesondere aus **FIG. 2****,** **FIG. 6** und **FIG. 7** hervorgeht, ein zweiteiliges Gehäuse, nämlich Abdeckung "Standard-Meter" SA (insbesondere als Gehäusehaube ausgestaltet) und Gehäuse- Unterschale U, mit einer lösbaren Verbindung zum Zusammenhalt der Gehäuseteile SA, U zur Aufnahme des "Standard-Meter" bestehend aus Zählermodul Z und Standardklemmenmodul K. Weiterhin ist das Standardklemmenmodul K mit einem Deckel SAK abgedeckt (siehe **FIG. 1** bis **FIG. 5**). Zwischen internen Modulen Z, K, IO, IR und externen Modul EO, ER, EK, EKR sind jeweils optische Schnittstellen OSE, OSI angeordnet, welche zur Kommunikation einschließlich Erkennung der Öffnung des geschützten Bereichs dienen.

Das in **FIG. 2** dargestellte Ausführungsbeispiel "Standard-Meter (Basiszähler)" besteht aus Zählermodul Z und Standardklemmenmodul K (Anschlussblock). Dieses ist bspw. einfach erweiterbar durch einen intelligenten Klemmendeckel A (mit externem Options-Modul EO) sowie erweiterbar durch ein externes Relais (+Optionsmodul) ER (Optionsmodul dient im dargestellten Beispiel lediglich der Weitergabe von Daten bzw. der Ansteuerung des/der Relais). Die im Feld SS1 enthaltenen Bezeichnungen sind Taster, DLC-LED, Relais-LED und AMR-LED und im FELD SS2 die Bezeichnungen PROG, EEPROM, Display, MLED und DO; siehe nachfolgende Beschreibung für diese Schaltungsteile/Bauelemente.

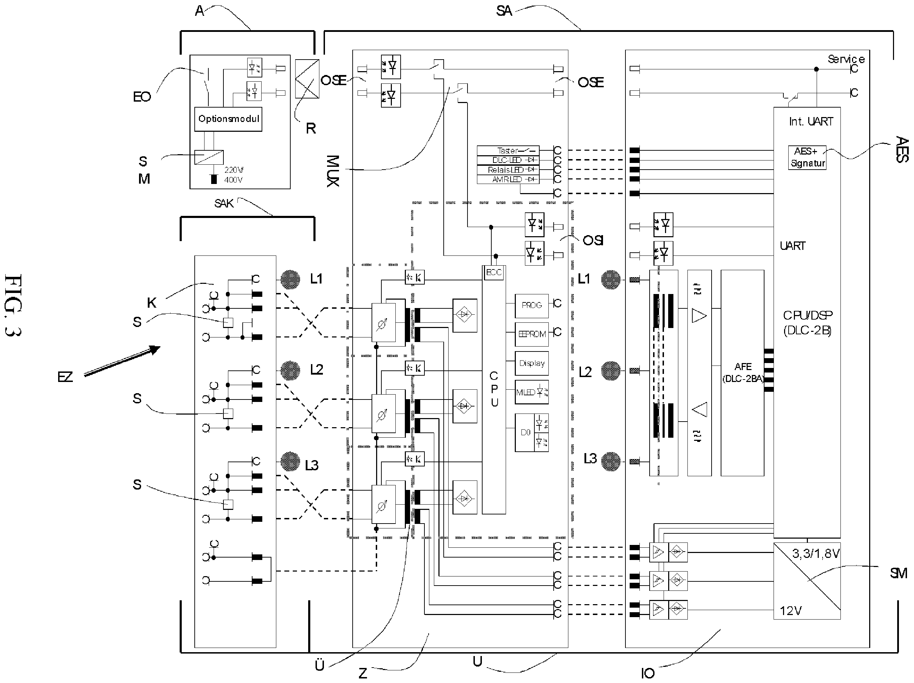

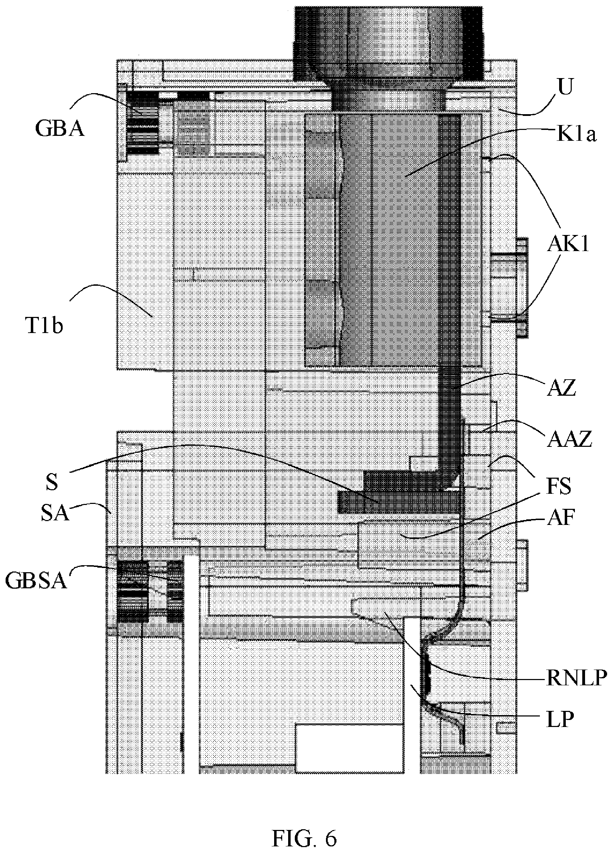

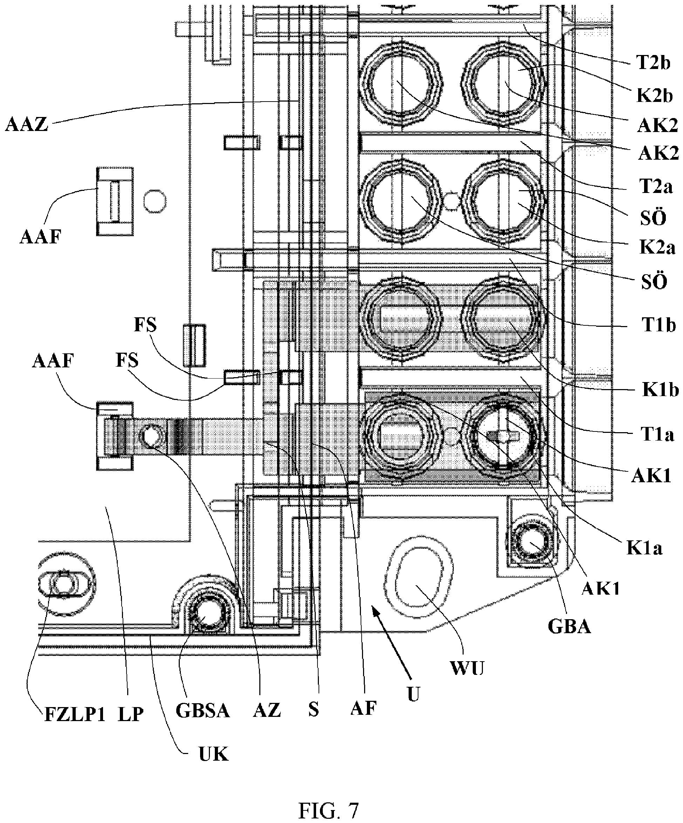

Das in **FIG. 3** dargestellte Ausführungsbeispiel besteht aus Standard-Meter mit zusätzlichem internen Optionsmodul IO (z.B. als "PLC-Zähler") sowie intelligentem Klemmendeckel A (externes Optionsmodul EO). Dieses ist bspw. einfach erweiterbar durch ein externes Relais (+Optionsmodul) ER. Dabei können die jeweils die Bauelemente (einschließlich LED's, MLED, Display, DO, PROG, Taster, siehe **FIG. 2** Bezugszeichen SS1 und SS2) tragenden und übereinander parallel liegenden Leiterplatten LP (siehe **FIG. 6** und **FIG. 7**) über Rastnasen RNLP und die oben liegenden Leiterplatte (in der Zeichnung nicht dargestellt) zusätzlich über beispielsweise in den vier Ecken angeordnete Führungszapfen FZLP1, welche sich jeweils von der Gehäuse-Unterschale U erheben, positioniert und gehalten werden.

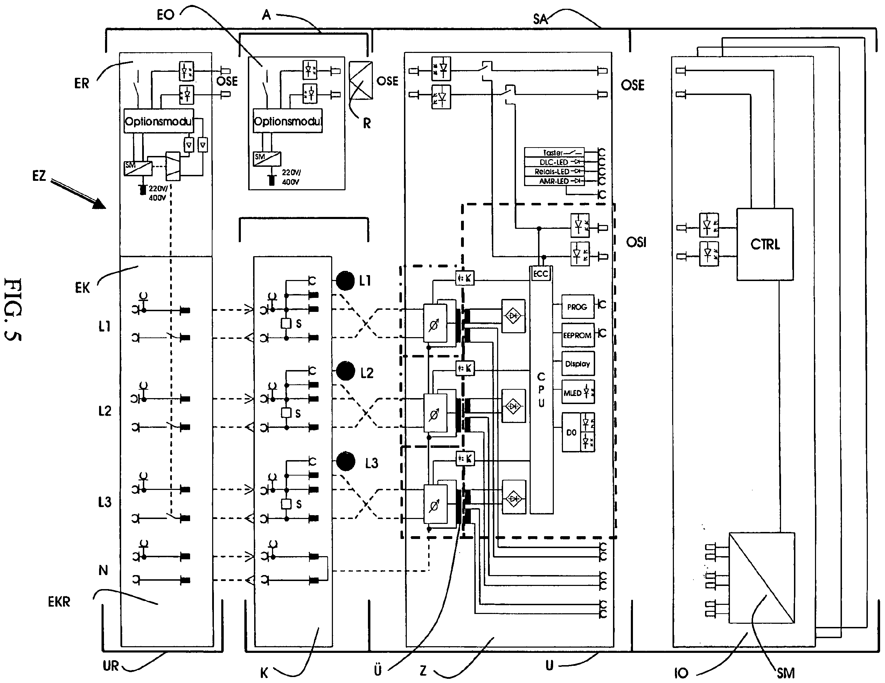

Das in **FIG. 5** dargestellte Ausführungsbeispiel zeigt einen erfindungsgemäßen Zähler EZ, bei dem das interne Optionsmodul IO als beliebiges Modul mit den entsprechenden Schnittstellen (insbesondere OSI, OSE) zum Zählermodul Z ausgebildet ist. Dies sind, je nach Bedarf der damit zu realisierenden Anwendung(en), im Wesentlichen die Schnittstelle zur Stromversorgung des Moduls, die optische Schnittstelle OSI zur Kommunikation mit dem Zählermodul Z und die Schnittstelle OSE zur Kommunikation mit einem eventuell vorhandenen externen Optionsmodul EO. Wie bereits erwähnt, kann das interne Optionsmodul IO dabei zur Kommunikationsanbindung des Zählers dienen (z.B. als PLC-Modul (1 oder 3-phasig), DSL, GPRS, etc. für WAN-Schnittstelle, oder M-Bus, ZigBee, Ethernet etc. für LAN-Schnittstelle).

Wie nachfolgend zunächst anhand der Modulstruktur beschrieben wird, weist das Klemmenmodul K einen Anschlussblock zum Netzanschluss L1, L2, L3, N, zum Anschluss der Stromversorgung SW der internen und/oder externen Module IO, IR EO, ER, EKR und zum Anschluss mindestens eines Shunt S auf. Im geschützten Bereich ist bei einer in **FIG. 1** bzw. **FIG. 3** dargestellten Ausführungsform als internes Modul ein Optionsmodul IO zur Kommunikationsanbindung des Zählers EZ zur bidirektionalen Datenkommunikation, insbesondere Fernauslesung verschlüsselter Daten, über das Klemmenmodul K in das Stromversorgungsnetz L1, L2, L3, N zu einer Zentrale vorgesehen. Zur bidirektionalen Daten-Übertragung mit einem externen Optionsmodul (z.B. zur weiteren Kommunikation über ein drahtgebundenes oder ein drahtloses Netz) weist das interne Optionsmodul IO eine weitere optische Schnittstelle OSE auf. Die Umschaltung der optischen Strecken erfolgt mittels der im Zählermodul Z angeordneten CPU und einem von diesem gesteuerten Multiplexer/Vielfachschalter MUX. Weiterhin ist bei einer in **FIG. 1** bzw. **FIG. 3** dargestellten Ausführungsform im geschützten Bereich als weiteres internes Modul ein mit dem Klemmenmodul K verbundenes internes Relaismodul IR angeordnet, welches mindestens ein vom internen Optionsmodul IO angesteuertes bistabiles Relais BI aufweist und welches zur Trennung des Endkunden vom Netz L1, L2, L3, N oder der Leistungsreduktion durch Abschaltung einzelner Phasen L1 bzw. L1, L2 dient.

Das Zählermodul Z weist einen Übertrager/Trafo Ü auf, dessen Primärseite mit dem Klemmenmodul K und dessen Sekundärseite sowohl mit einer Steuereinrichtung CPU des Zählermoduls Z zur Auswertung, Identifizierung und Anzeige der gelieferten Messsignale als auch mit in internen oder externen Modulen IO, IR EO, ER, EKR angeordneten Spannungswandlern SW verbunden ist.

Zur nachträglichen Erweiterung des Zählers EZ ist ein externes Relaismodul ER am Anschlussblock K1a, K1b; K2a, K2b; .. angebracht. Hierbei kann das externe Relaismodul ER ein Kommunikations-/Options-/Nachrüstmodul mit optischer Anbindung OSE an das Zähler- oder ein internes Optionsmodul Z, IO aufweisen. Weiterhin kann im als Gehäusehaube ausgestalteten Klemmendeckel A ein Klemmen- und Erweiterungsmodul EO als externes Options-/Nachrüstmodul mit optischer Anbindung OSE an das Zähler- oder ein internes Optionsmodul Z, IO oder es kann ein Reflektor R vorgesehen werden. Der Reflektor R ist insbesondere als Prisma (Schließen der optischen Übertragungsstrecke) ausgestaltet und kann beispielsweise angeklebt werden.

Das zweiteilige Gehäuse SA, U weist eine an den Stirnseiten der Seitenwände angeordnete umlaufende Dichtung auf, welche als Antenne im ISM 2-Band ausgestaltet sein kann. Vorzugsweise ist hierzu in der Stirnseite der Unterschale U eine Nut (wobei auch andere Querschnittsformen möglich sind) als umlaufender Kanal UK vorgesehen, in welchem die Stirnseite der Gehäusehaube SA eingreift (siehe **FIG. 6** und **FIG. 7**) und welche beispielsweise durch Schraubverbindung angepresst wird (siehe **FIG. 6** und **FIG. 7** Gewindebuchse GBSA).

Zum Schutz der Stromversorgung der Steuereinrichtung CPU des Zählermoduls Z und/oder eines internen Optionsmoduls Z, IO ist optional/nachrüstbar auf der Sekundärseite des Übertragers Ü oder nachfolgend in den Stromversorgungspfaden mindestens eine Sicherung S1, S2 angeordnet. Weiterhin ist optional/nachrüstbar zum Schutz nachfolgender Schaltungsteile des Energiezählers EZ auf der Primärseite des Übertragers Ü mindestens eine Thermosicherung S3 angeordnet (siehe **FIG. 1**).

Wie im Detail **FIG. 6** und **FIG. 7** aufzeigen, weist der Anschlussblock Einzelklemmen K1a, K1b; K2a, K2b; .., Auflager AK1; AK2; .. für die Einzelklemmen K1a, K1b; K2a, K2b; .. , den Shunt S, auf diesem aufliegende Anschlusszungen AZ und daran und/oder an der jeweiligen Einzelklemme K1a, K1b; K2a, K2b; .. befestigbare Anschlussfedern AF auf. Weiterhin weist die Unterschale U angeformte Trennwände T1a, T1b; T2a, T2b; .. zwischen den einzelnen Klemmen K1a, K1b; K2a, K2b; .. auf, welche als Führungen für den L-förmig ausgestalteten und Schrauböffnungen SÖ aufweisenden Deckel SAK dient, so dass bei in der Unterschale U verrastetem Deckel SAK jeweils eine geschlossene, durch den einen Schenkel SSAK (siehe **FIG. 8**) gegenüber dem Zählermodul Z abgegrenzte Kammer GR2 für das jeweilige Klemmenpaar K1a, K1b; K2a, K2b; .. ausgebildet ist (siehe auch **FIG. 8**). Der Schenkel SSAK kann in einen Schlitz der Unterschale U geführt werden und über Rastnasen mit dieser verrasten. Die Rastnasen können bei geöffnetem Deckel SA einfach von der Gegenseite, die seitlich außerhalb des Klemmenmoduls K und damit auch außerhalb des geschützten Bereichs GR2 liegt, durch Eindrücken z.B. mittels Metallstift gelöst werden. Der Shunt S ist hinter dem Schenkel SSAK stehend angeordnet und durch Gegenlager/ Fixierung Shunt FS geführt/stehend gehalten. Die stehende Anordnung des Shunt S erlaubt hier vorteilhaft gegenüber einer liegenden Anordnung einen kompakteren Aufbau. Nach Zusammenbau des Gehäuses, beispielsweise Aufschwenken der Gehäusehaube SA und Eindrehen (und Verplomben) der Schrauben in die Gewindebuchsen GBSA (Schließen des geschützten Bereichs) der Gehäuse-Unterschale U, kann dieses beispielsweise mittels seitlich am Klemmenmodul K (dessen Deckel SAK durch die darüber liegende Gehäusehaube verriegelt ist und nur die Schrauböffnungen SÖ zugänglich sind) angeordneter Laschen WU an einer Tragwand befestigt werden. Die Gehäusehaube SA greift dabei derart in (z.B. Nut oder Nut-ähnlich ausgebildete Oberfläche) bzw. auf den Deckel SAK ein, dass dieser ohne Entfernung der Gehäusehaube SA ebenfalls nicht mehr entfernt werden kann und somit das Klemmenmodul K in den geschützten Bereich (→ GR2) einbezogen wird (siehe auch **FIG. 8**).

Danach kann der als Gehäusehaube ausgestaltete Klemmendeckel A, beispielsweise durch Eindrehen der Schrauben (und Verplomben) in die Gewindebuchsen GBA, an der Gehäuse-Unterschale U befestigt werden, wodurch durch das in einer Öffnung der angrenzenden Seitenwand angeordnete Reflektor/Prisma P die (geteilte) Lichtleiterstrecke/Schnittstelle OSE geschlossen und die externen Module EO, ER, EK, EKR in den geschützten Bereich (siehe **FIG. 8** GR3) einbezogen werden. Damit führt jeder Öffnungsversuch der Gehäusehaube SA oder des Klemmendeckels A zu einer Unterbrechung an der Schnittstelle OSE, welche entsprechend (Zeit, Datum) protokolliert werden kann (mittels CPU und Speicher).

Vorzugsweise ist vorgesehen, dass die Anbindung der (geteilten) optischen Schnittstelle OSE an eines der internen Module (Z, K, IO, IR) durch Umstecken eines Verbindungskabels zwischen den internem Modulen (bzw. Bauelementen auf den Leiterplatten LP) erfolgt. Die Gehäusehaube SA weist ein Sichtfenster auf, wobei über an das Sichtfenster befestigte Lichtleiter das Licht von in der Unterschale U auf einer Leiterplatte LP angeordneten LEDs abgestrahlt wird. Weiterhin ist über weitere an das Sichtfenster befestigte Lichtleiter eine D0-Schnittstelle D0 (siehe **FIG. 1**) für Zähler(fern-) -auslesung und zur Ausgabe von Energiemesswerten oder Zählwerten ausgebildet.

In dem in **FIG. 8** dargestellten Ausführungsbeispiel enthält die Unterschale U einen Zwischenboden UZB, der den geschützten Raum GR1 zwischen Gehäusehaube SA und Unterschale U nochmals unterteilt in zwei getrennte geschützte Räume GR1a und GR1b. Der geschützte Raum GR1a, der durch die Verplombung PB1 bereits vom Hersteller/Vertreiber zugangsgesichert wird, enthält hierbei das Zählermodul Z. Der geschützte Raum GR1b, der Platz für mehrere (in der **FIG. 8**: 2) externe Options-/Nachrüstmodule EO (in der **FIG. 8**: EO (2), EO (3)) bietet, ist durch einen Zugang in der Unterschale zugänglich. Dies erlaubt dem Kunden (Messstellenbetreiber) dort optionale/zusätzliche Module einzufügen und anschließend diesen Raum GR1b mit einer entsprechenden Abdeckung AZU zu verschließen und dabei gegen unbefugten Zugriff zu sichern. Hierzu kann der Verschluss bspw. mittels selbstsichernder Schrauben/Sicherheitsschrauben (z.B. Einweg-Antrieb-Sicherungsschrauben oder Sicherheitsschrauben zum Aufbohren oder Einschlagen von Aluminiumstiften) SSS, Verschweißen oder auch weiterer Plombierung gesichert werden, falls erforderlich (der Zugang ist jedoch nach dem Einbau bereits durch die Verschraubung am Zählplatz gesichert). Weiterhin zeigt **FIG. 8** einen Netzanschlusskontakt NAK, der den Zugriff des externen Optionsmoduls EO auf den Netzanschluss im Klemmenmodul K ermöglicht (insbesondere Stromversorgung des externen Optionsmoduls EO, ggf. PLC-Anbindung). Der Netzanschlusskontakt NAK kann dabei beispielsweise als Metallstift ausgeführt sein. Hierzu sind im Deckel SAK des Klemmenmoduls entsprechende Aussparungen vorgesehen, die einen Durchgriff durch den Deckel SAK auf die jeweilige Klemme K1b, K2b, .. ermöglichen. Diese haben den Vorteil, dass ein entsprechender Kontaktstift nur geringes Spiel besitzen muss, da die Klemmen eine quasi feste Position besitzen. Im Gegensatz dazu müsste bei Nutzung der Schraubenöffnungen SÖ zum Zugriff auf die Schrauben mehr Spiel berücksichtigt werden, da die Eindrehtiefe der Schrauben von der Kabelstärke abhängt.

Darüber hinaus veranschaulicht **FIG. 8** die konstruktive Verriegelung der Abdeckung SAK des Standardklemmenmoduls durch die Gehäusehaube SA einerseits und den Klemmendeckel A, AK andererseits. Außerdem zeigt sie wie durch Anbringung des Klemmendeckels A, AK der geschützte Bereich GR3 entsteht, in dem der Kunde (Messstellenbetreiber) externe Module anbringen kann. Hierzu kann vorzugsweise im Klemmendeckel A, AK nach Anbringung des externen Optionsmoduls EO noch eine Abdeckung AEO für das externe Optionsmodul angebracht werden, die den geschützten Bereich GR3 in die Teilbereiche GR3a und GR3b unterteilt. Wird diese Abdeckung gegen Entfernen gesichert, beispielsweise durch Verschweißen, so ist der Bereich GR3b zusätzlich zugangsgeschützt (z.B. gegen Manipulation vor/während Montage), während der Bereich GR3a lediglich durch die Anbringung an einer Wand unzugänglich wird. **FIG. 8** zeigt weiterhin andeutungsweise Haken HSA in der Gehäusehaube SA, die in korrespondierende Erhebungen in der Unterschale U greifen und damit die Montage erleichtern bzw. die Anzahl notwendiger Plombierungsschrauben erniedrigen.

Nachfolgend werden die einzelnen Komponenten des erfindungsgemäßen Messgeräts/Zählers EZ nochmals stichpunktartig beschrieben. Beim Zählermodul Z ist jede Phase gegeneinander potentialgetrennt, außerdem Potentialtrennung gegenüber dem Digitalteil (Messauswertung) und dieses weist folgende Komponenten (siehe beispielsweise **FIG. 1**) auf:
∘ Interfaces:
   ▪ 1 Sende- und 1 Empfangsdiode zur Kommunikation (inkl. Sabotageerkennung (Tamper detection)) mit externem Options-Nachrüstmodul EO oder einfacher Sabotageerkennung über Prisma P einschließlich Polling der verriegelten Stecke), ▪ 1 Sende- und 1 Empfangsdiode zur Kommunikation mit internem Optionsmodul IO (inkl. Sabotageerkennung (Tamper detection)).
∘ Spannungsversorgung:
   ▪ Externes Options-/Nachrüstmodul EO: bis zu 3-phasig (L1,L2,L3,N) mit Phasen- und Nulldurchgangserkennung,
   ▪ Internes Options-/Nachrüstmodul IO: bis zu 3-phasig (L1,L2,L3,N) mit Phasen- und Nulldurchgangserkennung, potentialgetrennte Niederspannungsversorgung.
∘ Messchip(s) für die Phasen L1, L2, L3 mit Optokoppler zur Weitergabe der Messwerte an die Steuereinrichtung CPU.
∘ MLED (Metrologische LED) (= Puls-LED, gibt Pulse proportional der entnommenen Energie aus) (**FIG**. **2** siehe SS2).
∘ Display beispielsweise als LCD-Anzeige ausgestaltet (**FIG. 2** siehe SS2).
∘ D0-Schnittstelle (nach IEC62056-21) für Zähler(fern-)auslesung (zur Ausgabe der Registerwerte (mit Energiemesswerten/Zählwerten)) (**FIG. 2** siehe SS2).
∘ PROG: Programmierschnittstelle (**FIG. 2** siehe SS2).
∘ EEPROM: zur Speicherung und Überprüfung der Energiewerte (**FIG. 2** siehe SS2).
∘ Vom internen Options-/Nachrüstmodul IO können mehrere LEDs und Taster (im Beispiel gemäß **FIG. 1****:** 3 LEDs und 1 Taster; **FIG. 2** siehe SS1) angesteuert bzw. ausgewertet werden.
∘ LEDs zur Signalisierung etc. , z.B. Kommunikations-Status.
∘ Taster z.B. zum Auslesen/Durchblättern der letzten Messwerte (**FIG. 2** siehe SS1).
∘ CPU (Mikrocomputer, Mikroprozessor mit Programmspeicher):
   ▪ Optional/zusätzlich: Signierung mit ECC (Elliptic Curve Cryptography) (siehe beispielsweise **FIG. 2**),
   ▪ Messauswertung.
∘ Sicherungen (optional/nachrüstbar):
   ▪ Sicherungen S1 auf Sekundärseite des Trafos Ü in den Stromversorgungspfaden für die CPU; zum Schutz der Stromversorgung der CPU,
   ▪ Sicherungen S2 auf Sekundärseite des Trafos Ü in Stromversorgungspfaden für internes Optionsmodul IO; können auch verlagert sein ins Optionsmodul; dienen zum Schutz der Stromversorgung und damit der Betriebsbereitschaft des Zählerteils Z,
   ▪ Thermosicherungen S3 im Trafo Ü zum Schutz der nachfolgenden Schaltungsteile.

Das Klemmenmodul ist entweder als Standardklemmenmodul, welches enthält:
▪ Messshunts, Messwandler oder Rogowski-Spulen,
▪ Anschluss für Stromversorgung der Zählereinheit Z,
▪ Optional/Nachrüstbar: Anschluss für PLC-Ankopplung bzw. Stromversorgung für internes Optionsmodul IO,
oder in optionaler/nachrüstbarer Erweiterung:
▪ Anschluss für internes Relaismodul IR.

Das Gehäuse weist im Klemmenmodul K im Wesentlichen folgende Merkmale auf (siehe **FIG. 6** und **FIG. 7**):
▪ Auflager AK1, AK2: in der Gehäuseunterschale U sind Auflager, auf denen die Klemme K1a, K1b; K2a, K2b; .. aufliegt; hierdurch wird ein vollständiges Aufliegen auf der Gehäuseunterschale U vermieden bzw. Wärmeabfuhr von den Klemmen K1a, K1b; K2a, K2b; .. ermöglicht,
▪ Auflager Shunt AAZ: in der Gehäuseunterschale U sind Auflager, auf denen die Anschlusszungen AZ aufliegen (zwischen denen der Messshunt S angebracht ist); dienen zur Stabilisierung,
▪ Gegenlager/Fixierung FS Shunt S: "Dome" in der Gehäuseunterschale U, die zur Fixierung der Anschlusszunge AZ mit Messshunt S dienen,
▪ Fixierungen AAF für Anschlussfeder AF: Auflager in der Gehäuseunterschale U, die zur Fixierung der Anschlussfeder AF dienen,
▪ Anschlussfeder AF: ist jeweils entweder an der Anschlusszunge AZ oder an der Klemme fixiert und stellt die Netzanschlüsse (L1, L2, L3 und N) für das interne Modul IO (Options-/Nachrüstmodul) zur Verfügung; Feder AF dient auch dem Toleranzausgleich (aufgrund Bauteiltoleranzen, Temperaturschwankungen oder ähnlichem).

Besonders hervorzuheben ist hier:
- Stehender Shunt S (dadurch kann verfügbarer Platz besser genutzt werden),
- Anschlussfeder AF.

Weitere Komponente des erfindungsgemäßen Messgeräts/Zählers EZ ist das optionale, nachrüstbare interne Relaismodul IR, welches angesteuert vom internen Options-/Nachrüstmodul IO (CPU/DSP (DLC-2B)) zur Trennung des Endkunden vom Netz dient und welches enthält:
∘ bistabile Relais mit entspr. Komponenten zur Ansteuerung,
∘ Relais können getrennt oder gemeinsam geschaltet werden (für Leistungsreduktion; getrennt z.B. zur Abschaltung einzelner Phase, an der nur Klimaanlagen hängen (vorzugsweise für USA).

Ebenfalls optional/nachrüstbar ist das interne Optionsmodul IO, welches wie folgt stichpunktartig beschrieben werden kann:
∘ Dient vorzugsweise zur Kommunikationsanbindung des Zählers (z.B. PLC-Modul (1 oder 3-phasig) für WAN-Schnittstelle, auch M-Bus, ZigBee, GPRS, etc.),
∘ Über optische Schnittstelle OSI verbunden mit Zählermodul Z (zur Übergabe von Messwerten, Parametrierung des Zählers EZ, etc.),
∘ Kann internes Relais IR, externes Relais ER sowie externes Optionsmodul EO steuern; verwendet hierzu uni- oder bidirektionale Kommunikation,
∘ Enthält AES- und- Signatur-Modul (siehe **FIG. 3** AES) zur Verschlüsselung der (Fern-) Kommunikation, wie dies in der nicht vorveröffentlichten Deutschen Patentanmeldung 10 2008 058 264.6 der Anmelderin, welche durch die Bezugnahme ergänzend inhaltlich zur vorliegenden Patentanmeldung beschrieben ist,
∘ Enthält eigene Stromversorgung SM,
∘ Enthält Phasen- und Nulldurchgangserkennung (Schmitt-Trigger in den Stromversorgungspfaden zu SM; siehe **FIG. 1****,** **FIG. 3** und **FIG. 4**),
∘ Kann für Tarifsteuerung verwendet werden.

Ebenfalls optional/nachrüstbar ist das externe Klemmen- und Erweiterungsmodul EO (angeordnet im als Gehäusehaube ausgestalteten Klemmendeckel A), welches wie folgt stichpunktartig beschrieben werden kann:
∘ die Abdeckung A, die über dem Klemmenmodul EO benötigt wird (u.a. als Schutz vor Zugriffen auf die stromführenden Netzleitungen) kann vorteilhaft dazu verwendet werden, Zusatzfunktionalität platzsparend zu integrieren,
∘ Dient bspw. zur Kommunikationsanbindung des Zählers EZ (z.B. PLC-Modul IO (1 oder 3-phasig) für Inhouse-Kommunikation, M-Bus, ZigBee, GPRS, etc.),
∘ Über optische Schnittstelle OSE verbunden mit Zählermodul Z,
∘ Auch Sabotageerkennung (Öffnung des Klemmendeckels A) kann dann einfach über diese Schnittstelle OSE realisiert werden (z.B. durch regelmäßige Kommunikation),
∘ Enthält (siehe internes Optionsmodul IO) AES-und-Signatur-Modul AES zur Verschlüsselung der (Fern)Kommunikation (siehe beispielsweise **FIG.** 3),
∘ Enthält (siehe internes Optionsmodul IO) eigene Stromversorgung SW,
∘ Enthält (siehe internes Optionsmodul IO) Phasenerkennung,
∘ Kann für Tarifsteuerung (siehe internes Optionsmodul IO) verwendet werden.

Ebenfalls optional/nachrüstbar ist das externe Klemmen- + Relaismodul EKR (Externes Relais- + Optionsmodul, angeordnet im als Gehäusehaube ausgestalteten Klemmendeckel A), welches wie folgt stichpunktartig beschrieben werden kann:
▪ Das Optionsmodul in EKR entspricht im Wesentlichen dem externem Optionsmodul EO im Klemmendeckel AK,
▪ Zusätzlich ist das Optionsmodul für die Ansteuerung des/der Relais zuständig,
▪ Zur Stromversorgung SW im externen Klemmen- + Relaismodul EKR kann vorteilhaft die Relaiswicklung verwendet werden, so dass dadurch kein zusätzlicher Trafo nötig ist.

∘ Relais:
   ▪ Trennen vom Netz,
   ▪ Leistungsreduktion.

Die Klemmendeckel können wie folgt ausgestaltet werden:
∘ Standardklemmendeckel:
   ▪ ohne weitere Funktion.
∘ Klemmendeckel mit Sabotageerkennung (= Klemmendeckel A, AK):
   ▪ ist meist höher als der Standardklemmendeckel ausgeführt und enthält zusätzlich ein Prisma P für die Sabotageerkennung; Prisma P dient als Reflektor für die optische Schnittstelle OSE zum Zählermodul Z,
   ▪ Erweiterbar durch Klemmen- und Erweiterungsmodul EO (Externes Optionsmodul EO im Klemmendeckel A, wie weiter oben beschrieben), in diesem Fall tritt anstelle des Reflektors die Gegenseite für die optische Schnittstelle OSE zum Zählermodul Z, d.h. entsprechende Sende- und Empfangsdioden und Ausführung als geteilte optische Schnittstelle.

Prinzipiell sind im Rahmen der Erfindung beliebige Kombinationen der verschiedenen Module möglich, nur die Option/Nachrüstung internes und externes Relaismodul IR und ER schließt sich gegenseitig aus bzw. ist nicht wirklich sinnvoll, da das Relais nur einmal benötigt werden. Merkmale des erfindungsgemäßen Messgeräts/Zählers EZ sind:
- Externes Klemmen- und Relaismodul EKR, das am Klemmenblock angebracht werden kann zur nachträglichen Erweiterung des Zählers EZ um Relais; hierbei ist eine einfache Erweiterung (Montage) vor Ort möglich; Klemmen- und Relaismodul EKR stellt dabei (vorteilhaft) nach außen wieder die Standardklemmen zur Verfügung.
- Externes Relaismodul ER mit integriertem Kommunikations-/Optionsmodul EO (mit optischer Anbindung).
- Reflektor (Prisma P) zur optischen Sabotageerkennung im Klemmendeckel A, d.h. Sabotageerkennung wird realisiert über optische Strecke; der Reflektor P wirft das empfangene Signal vom optischen Sender des Zählermoduls Z auf dessen optischen Empfänger zurück (→ Sende-Empfangs-Schleife); beim Öffnen des Zählers EZ wird optische Strecke unterbrochen; dies kann im Zählermodul Z z.B. durch regelmäßige Überprüfung der Schnittstelle OSE festgestellt werden.
- Relaiswicklung (im Klemmen- und Relaismodul) kann gleichzeitig als Trafo zur Stromversorgung für ein enthaltenes Optionsmodul EO verwendet werden, d.h. kein Extra-Trafo ist nötig.
- Anschluss des internen Optionsmoduls IO durch Kontaktfeder AF, diese wird an Anschlusszunge AZ fixiert, z.B. angeschweißt.
- Anschlussblock
   ∘ Ist in Klemme integriert,
   ∘ erfüllt in vorteilhafter Weise gleichzeitig bis zu vier Funktionen:
      ▪ Netzanschluss,
      ▪ Kontaktierung für Optionsmodul, d.h. Zugang zu Netzanschluss für interne und externe Optionsmodule,
      ▪ Shunt-Anschluss oder Anschluss für Messwandler oder Rogowski-Spule(n),
      ▪ Adaptierung von PLC-Board (in Klemmen integriert), d.h. Schnittstelle für PLC-Board zum Netz (zur PLC-Kommunikation).
   ∘ Konstruktive Verriegelung der Abdeckung SAK des Standardklemmenmoduls durch die Gehäusehaube SA und den Klemmendeckel (A, AK).

Zusammenfassend weist das erfindungsgemäße Messgerät/Zähler EZ folgende Vorteile auf:
- Optimierte Lösung/Realisierung der neuen/zusätzlichen Funktionen, d.h. kostengünstige, kompakte, flexible, installationsfreundliche Lösung.
- Klemme integriert (als zentraler Anschluss) mehrere Funktionen gleichzeitig:
   ∘ Netzanschluss,
   ∘ Messung via Shunt S oder Messwandler oder Rogowski-Spule,
   ∘ Adaption (Kontaktierung) für internes Optionsmodul IO (PLC; insbesondere DLC-Kommunikation), d.h. Schnittstelle für PLC-Board zum Netz,
   ∘ Adaption für (externes oder internes) Relais-Modul ER, IR,
   ∘ Adaption für externes Optionsmodul EO (Zusatzmodul im Deckel A, AK).
- Optische Schnittstelle zum Klemmendeckel
   ∘ Detektion der Öffnung des Deckels (= Klemmendeckel A, AK) oder der Gehäuseabdeckung SA via Reflektor P bzw. durch einfache Kommunikation über optische Schnittstelle OSE mit externem Optionsmodul (d.h. einfache Realisierung der Sabotageerkennung),
   ∘ Gleichzeitige Kommunikation über optische Schnittstelle OSE/OSI, d.h. für Sabotageerkennung kein zusätzlicher Kommunikationsoverhead nötig,
   ∘ Schnittstellentest ist einfach via Reflektor P (bei der Fertigung) möglich.
- Potentialtrennung durch Verwendung separater Massen im System, dadurch autarke Module (einzelne Phasen, Zählwerk, Auswertung); Zählerteil ist potentialgetrennt von Controllerteil, keine Potential-/Masseverschleifungen möglich, Verbindung besteht durch optische Strecken OSI, OSE. Hierdurch wird eine verbesserte Sicherheit einschließlich Rückwirkungsfreiheit und EMV ermöglicht.
- Modulares Konzept:
   ∘ Zähler EZ kann nach jeweiligem Bedarf modular zusammengebaut werden bzw. Standardvarianten können vorgefertigt werden; bei geändertem Bedarf des Kunden können weitere Funktionalitäten einfach nachgerüstet werden. Dies kann dann ohne Austausch des Zählers erfolgen, sondern durch Austausch von Modulen oder einfache Anbringung neuer Module.

- Als Bezugspotential für die Messelektronik eines Phasenpfades wird die jeweilige Phase verwendet (d.h. Massen des Messsystems beziehen sich auf die jeweilige Phase), dadurch ergibt sich eine genauere Messung und eine bessere Störunterdrückung.
- Störungen auf Primärseite haben keinen Einfluss auf Sekundärseite und umgekehrt (verbesserte EMV).
- hohe Trennspannungen durch entsprechenden Aufbau der Leiterplatte LP (bzw. mehrerer übereinander liegender Leiterplatten) und des Gehäuses (Leiterplatte LP durch Rastnase RNLP an der Gehäuse-Unterschale U befestigt) sowie hohe Isolationsfestigkeit möglich, z.B. 12 kV, Schutz vor Blitzen, wichtig für Gebiete mit überwiegend Freileitungen.
- zentrale Stromversorgung über das Zählermodul Z, wodurch keine weiteren Stromversorgungen in den Optionsmodulen mehr nötig und die Verlustleistungen im System geringer sind.
- durch mechanische Verriegelung der Relais kann ein versehentliches oder unzulässiges (Gesetzesbestimmungen) Abschalten des Endverbrauchers verhindert werden.
- Montagehilfe am Relaisblock zur sicheren und einfachen Montage durch eine Person, d.h. Relaisblock kann vor der Verschraubung durch geeignete mechanische Maßnahme (z.B. Schnappmechanismus, Presspassung) fixiert werden.
- Verwendung von bistabilen Relais (dadurch Vermeidung von hohen Verlustleistungen im Vergleich zu monostabilen Relais).
- Relaiswicklung (im Klemmen- und Relaismodul) kann gleichzeitig als Trafo für ein enthaltenes Optionsmodul verwendet werden und es ist kein Extra-Trafo nötig.
- Kundennummer bzw. Zählpunktbezeichnung wird in intelligentem Deckel A (oder SA) integriert, wodurch bei Messstellenbetreiberwechsel nur ein Wechsel des Deckels A mit den entsprechenden Merkmalen nötig ist (da Kundennummer abrechnungsrelevant, damit auch zulassungsrelevant ist, darf dies nur durch eine beiderseits autorisierte Person erfolgen).
- Zentrale Stromversorgung als Quelle für autarke Stromversorgung der Module, d.h. der zentrale Klemmenblock ermöglicht Zugang zum Stromnetz zur Versorgung, daher kein zusätzlicher Zugang oder Batterie nötig. Hierfür weist vorzugsweise der Deckel SAK des Klemmenmoduls K auch Aussparungen auf, die einen Zugriff auf die Klemmen K1b, K2b,... vom geschützten Bereich GR3 aus ermöglichen.

Hervorzuheben ist, dass im Rahmen der Erfindung die Kommunikation der Nachrüstmodule, beispielsweise Klemmen- und Erweiterungsmodul EO oder internes Optionsmodul IO mit dem Standard-Meter (Basiszähler)" (siehe FIG. 2) oder untereinander über optische Strecken erfolgt, wodurch sowohl eine galvanische Trennung ermöglicht als auch eine Rückbeeinflussung des Messgeräts/Energiezähler EZ zuverlässig verhindert wird, d.h. trotz modularen, nachrüstbaren Aufbau wird eine Sicherung vor Manipulationen sichergestellt. Wird in missbräuchlicher Absicht von dem Manipulanten beispielsweise ein Kurzschluss hergestellt, so erfolgt beim erfindungsgemäßen Konzept nur eine segmentweise Zerstörung, nämlich des internen Netzteils, und diese wird protokolliert. Grundlage ist beim erfindungsgemäßen Messgerät/Energiezähler EZ, dass über den Reflektor R entweder eine gesendete Signatur/Telegramm (ECC bzw. AES-und-Signatur-Modul AES, siehe beispielsweise **FIG. 2** und **FIG. 3**) unverändert (1:1) oder - bei einer entsprechenden Nachrüstung - eine entsprechende (beispielsweise zu erwarteten Zeitpunkten) Antwort (beispielsweise Telegramm als Quittung) über die optischen Strecken empfangen wird. Die Erfindung ist nicht auf die dargestellten und beschriebenen Ausführungsbeispiele beschränkt, sondern umfasst auch alle im Sinne der Erfindung gleichwirkenden Ausführungen. Im Rahmen der Erfindung kann das erfindungsgemäße Messgerät, insbesondere Energiezähler EZ in Modulbauweise, auch beim Gegenstand gemäß der nicht vorveröffentlichten Deutschen Patentanmeldung 10 2008 058 264.6 der Anmelderin eingesetzt werden, nämlich einem Messgerät, mit Datenkommunikation zu mindestens einem System mit der Möglichkeit vom System über die Datenkommunikation zurückgelieferte Messdaten als die eigenen zu identifizieren und eine Manipulation der Messwerte auszuschließen und somit diese zurückgelieferten Messdaten vertrauenswürdig zur weiteren Verarbeitung/Auswertung oder Anzeige bereitzustellen, welches aufweist:
- mindestens eine Kommunikationsschnittstelle zu Komponenten eines Systems, welches mindestens in der Lage ist, signierte und oder verschlüsselte Messwerte zu empfangen, in einem Speicher aufzubewahren und zurückzuliefern, als auch Zeitinformationen bezogen auf eine Zeitreferenz anzubieten,
- mindestens ein Messmodul, welches den von mindestens einem Sensor gelieferten Messsignalen Energiemesswerte oder Zählerstände zuordnet,
- mindestens einen Speicher für den zuletzt ermittelten Energiemesswert oder Zählerstand (kurz: Messwert),
- mindestens einen Speicher für den Zeitstempel, welcher im Zeitmodul zu dem zuletzt erzeugten Messwert ermittelt wurde,
- mindestens ein Zeitanpassungsmodul, welche die über die Kommunikationsschnittstelle vom System angebotene Zeit überprüft und die lokale Zeit im Zeitmodul nachführt,
- mindestens einen Speicher für die dem Messgerät zugewiesene Identifikation,
- mindestens einen Speicher für den oder die zum Verschlüsseln und / oder Signieren benötigten Schlüssel,
- mindestens einen Verschlüsselungs- und / oder Signatur-Kodierer, welcher unter Verwendung der Schlüssel im Schlüsselspeicher die den vorgenannten Speichern angebotenen Informationen einschließlich der Gültigkeits- und Vertrauenskennzeichen mit Informationen zur Überprüfung der Unversehrtheit der Daten versieht und in einem Datensatz zusammenfasst und mindestens der Kommunikationsschnittstelle zur Übertragung übergibt,
- mindestens einen Verschlüsselungs- und / oder Signatur-Dekodierer, welcher unter Verwendung der Schlüssel im Schlüsselspeicher, die über die Kommunikationsschnittstelle gelieferten Datensätze mit Messwerten auf Unversehrtheit des Dateninhalts und die Identifikation des Messgeräts überprüfen kann, und bei erfolgreicher Überprüfung diese Daten zur weiteren Verarbeitung/Auswertung oder Anzeige bereitzustellen.

Vorteil des erfindungsgemäßen Messgeräts/Zählers EZ ist, dass der Hersteller den Zähler auf einfache und günstige Art auf die individuellen Bedürfnisse des Kunden (z.B. Netzbetreiber) anpassen kann und je nach Bedarf ein (oder auch mehrere) Kommunikationsmodule bestücken kann oder nicht. Dies ermöglicht im Gegensatz zum Stand der Technik die einfache Realisierung verschiedener Varianten auf Basis des gleichen Basiszählers, der somit mehr Einsatzmöglichkeiten hat, wodurch ein höherer Absatz und dadurch günstigere Zähler möglich werden. Während beim Stand der Technik beispielsweise eine einphasige Powerline-Ankopplung fest auf Phase L3 implementiert ist, kann beim erfindungsgemäßen Messgerät/Zähler EZ je nach Bedarf beispielsweise ein Options-/Nachrüstmodul mit ein- oder dreiphasiger Ankopplung in den Zähler EZ integriert werden.

Ferner ist die Erfindung bislang auch noch nicht auf die im Patentanspruch 1 definierte Merkmalskombination beschränkt, sondern kann auch durch jede beliebige andere Kombination von bestimmten Merkmalen aller insgesamt offenbarten Einzelmerkmale definiert sein. Dies bedeutet, dass jedes Einzelmerkmal des Patentanspruchs 1 weggelassen bzw. durch mindestens ein an anderer Stelle der Anmeldung offenbartes Einzelmerkmal ersetzt werden kann.

## Patentansprüche

1. Messgerät, insbesondere Energiezähler (EZ) in Modulbauweise, welcher aufweist:
• ein zweiteiliges Gehäuse (SA, U) mit einer Abdeckung (SAK) oder einer Gehäusehaube (SA) und einer Gehäuse- Unterschale (U) und mit einer lösbaren Verbindung zum Zusammenhalt der Gehäuseteile,
• mindestens ein in einem geschützten Bereich angeordnetes internes Modul (Z, K, IO, IR),
• mindestens ein außerhalb des geschützten Bereichs angeordnetes externes Modul (EO, ER, EK, EKR) und
• mindestens eine im internem Modul (Z, K, IO, IR) und/oder externem Modul (EO, ER, EK, EKR) angeordnete optische Schnittstelle (OSE, OSI), welche zur Kommunikation zwischen dem internen Modul (Z, K, IO, IR) und dem externen Modul (EO, ER, EK, EKR) einschließlich Erkennung der Öffnung des geschützten Bereichs dient.

2. Energiezähler nach Anspruch 1, **dadurch gekennzeichnet, dass** im geschützten Bereich als interne Module ein Zählermodul (Z) und ein Klemmenmodul (K) angeordnet sind, wobei das Klemmenmodul (K) einen Anschlussblock (K1a, K1b; K2a, K2b; ..) zum Netzanschluss (L1, L2, L3, N), zum Anschluss der Stromversorgung (SM, SW) der internen und/oder externen Module (IO, IR EO, ER, EKR) und zum Anschluss mindestens eines Shunt (S), eines Messwandlers oder einer Rogowski-Spule und dass das Klemmenmodul (K) einen separaten Deckel (SAK) aufweist.

3. Energiezähler nach Anspruch 2, **dadurch gekennzeichnet, dass** im geschützten Bereich als internes Modul ein mit dem Zählermodul (Z) über die optische Schnittstelle (OSI) verbundenes Options-/Nachrüstmodul (IO) zur Kommunikationsanbindung des Zählers (EZ) zur bidirektionalen Datenkommunikation, insbesondere Fernauslesung verschlüsselter Daten, über das Klemmenmodul (K) in das Stromversorgungsnetz (L1, L2, L3, N) zu einer Zentrale vorgesehen ist, dass zur bidirektionalen Daten-Übertragung mit einem externen Options-/Nachrüstmodul das interne Optionsmodul (IO) eine weitere optische Schnittstelle (OSE) aufweist und dass das interne Optionsmodul (IO) und/oder das externe Optionsmodul (EO) zur bidirektionalen Daten-Übertragung über ein drahtgebundenes oder ein drahtloses Netz dienen.

4. Energiezähler nach Anspruch 2 oder 3, **dadurch gekennzeichnet, dass** im geschützten Bereich als weiteres internes Modul ein mit dem Klemmenmodul (K) verbundenes internes Relaismodul (IR) angeordnet ist, welches mindestens ein vom internen Optionsmodul (IO) angesteuertes bistabiles Relais (BI) aufweist und welches zur Trennung des Endkunden vom Netz (L1, L2, L3, N) oder Abschaltung einzelner Phasen (L1) dient.

5. Energiezähler nach Anspruch 2, **dadurch gekennzeichnet, dass** das Zählermodul (Z) einen Übertrager (Ü) aufweist, dessen Primärseite mit dem Klemmenmodul (K) und dessen Sekundärseite sowohl mit einer Steuereinrichtung (CPU) des Zählermoduls (Z) zur Auswertung, Identifizierung und Anzeige der gelieferten Messsignale als auch mit in
Spannungswandlern (SW, SM) verbunden ist oder dass eine Relaisspule im Klemmen- und Relaismodul (EKR) gleichzeitig als Transformator für die Stromversorgung (SW) des im Klemmen- und Relaismodul (EKR) enthaltenen Optionsmoduls dient.
enthaltenen Optionsmoduls dient.

6. Energiezähler nach Anspruch 2, **dadurch gekennzeichnet, dass** zur nachträglichen Erweiterung des Zählers (EZ) ein externes Relaismodul (ER) am Anschlussblock (K1a, K1b; K2a, K2b; ..) angebracht ist und dass das externe Relaismodul (ER) ein Kommunikations-/Optionsmodul mit optischer Anbindung (OSE) an das Zähler- oder ein internes Optionsmodul (Z, IO) aufweist.

7. Energiezähler nach Anspruch 2, **dadurch gekennzeichnet, dass** im als Gehäusehaube ausgestalteten Klemmendeckel (A) ein Klemmen- und Erweiterungsmodul (EO) als externes Options-Nachrüstmodul mit optischer Anbindung (OSE) an das Zähler- oder ein internes Options-/Nachrüstmodul (Z, IO) oder ein Reflektor (R) angeordnet ist und dass der Reflektor (R) als Prisma ausgestaltet ist.

8. Energiezähler nach Anspruch 7, **dadurch gekennzeichnet, dass** die Kundennummer bzw. Zählpunktbezeichnung in einem Speicher eines im als Gehäusehaube ausgestalteten Klemmendeckel (A, AK) integrierten externen Optionsmodul (EO) gespeichert ist, dass im Klemmendeckel (A, AK) eine zusätzliche Abdeckung (AEO) derart angebracht ist, dass für das externe Optionsmodul (EO) ein weiterer geschützter Bereich (GR3b) ausbildet wird und dass die Gehäusekonstruktion derart ausgebildet ist, dass die Abdeckung (SAK) des Klemmenmoduls sowohl durch die Gehäusehaube (SA) als auch durch den Klemmendeckel (A, AK) verriegelt wird.

9. Energiezähler nach Anspruch 1, **dadurch gekennzeichnet, dass** das zweiteilige Gehäuse (SA, U) an den Stirnseiten einen umlaufenden Kanal (UK) aufweist, dass der umlaufende Kanal (UK) sich in der Abdeckung (SAK) fortsetzt, dass das zweiteilige Gehäuse (SA, U) eine an den Stirnseiten der Seitenwände angeordnete umlaufende Dichtung aufweist und dass die an den Stirnseiten der Seitenwände angeordnete umlaufende Dichtung als Antenne im ISM 2-Band ausgestaltet ist.

10. Energiezähler nach Anspruch 5, **dadurch gekennzeichnet, dass** zum Schutz der Stromversorgung der Steuereinrichtung (CPU) des Zählermoduls (Z) und/oder eines internen Optionsmoduls (Z, IO) auf der Sekundärseite des Übertragers (Ü) oder nachfolgend in den Stromversorgungspfaden mindestens eine Sicherung (S1, S2) angeordnet ist und/oder dass zum Schutz nachfolgender Schaltungsteile des Energiezählers (EZ) auf der Primärseite des Übertragers (Ü) mindestens eine Thermosicherung (S3) angeordnet ist.

11. Energiezähler nach Anspruch 2, **dadurch gekennzeichnet, dass** der Anschlussblock aus Einzelklemmen (K1a, K1b; K2a, K2b; ..), Auflagern (AK1; AK2; .., AAZ) für die Einzelklemmen (K1a, K1b; K2a, K2b; ..) und dem Shunt (S), auf diesen aufliegenden Anschlusszungen (AZ) und daran und/oder an der jeweiligen Einzelklemme (K1a, K1b; K2a, K2b; ..) befestigbaren Anschlussfedern (AF) besteht.

12. Energiezähler nach Anspruch 1, **dadurch gekennzeichnet, dass** die Gehäusehaube (SA) ein Sichtfenster aufweist, dass über an das Sichtfenster befestigte Lichtleiter das Licht von in der Unterschale (U) auf einer Leiterplatte (LP) angeordneten LEDs abgestrahlt wird und dass über weitere an das Sichtfenster befestigte Lichtleiter eine D0-Schnittstelle (D0) für Zähler(fern-) -auslesung und zur Ausgabe von Energiemesswerten oder Zählwerten ausgebildet ist.

13. Energiezähler nach Anspruch 2, **dadurch gekennzeichnet, dass** die Unterschale (U) angeformte Trennwände (T1a, T1b; T2a, T2b; ..) zwischen den einzelnen Klemmen (K1a, K1b; K2a, K2b; ..) aufweist, welche als Führungen für den L-förmig ausgestalteten und Schrauböffnungen (SÖ) aufweisenden Deckel (SAK) dient, so dass bei in der Unterschale (U) verrastetem Deckel (SAK) jeweils eine geschlossene, durch den einen Schenkel (SSAK) gegenüber dem Zählermodul (Z) abgegrenzte Kammer (GR2) für das jeweilige Klemmenpaar (K1a, K1b; K2a, K2b; ..) ausgebildet ist, dass der Shunt (S) stehend auf dem Auflager (AK1; AK2; ..) angeordnet und durch die Trennwand (T1a, T2a, ..) geführt ist und dass der Deckel (SAK) des Klemmenmoduls (K) Aussparungen aufweist, die einen Zugriff auf die Klemmen (K1b, K2b,...) vom geschützten Bereich (GR3) aus ermöglichen.

14. Energiezähler nach Anspruch 1, **dadurch gekennzeichnet, dass** die Anbindung der optischen Schnittstelle (OSE) an eines der internen Module (Z, K, IO, IR) durch Umstecken eines Verbindungskabels zwischen den internen Modulen erfolgt oder dass die Anbindung der optischen Schnittstelle (OSE) an eines der internen Module (Z, K, IO, IR) durch einen elektronischen Multiplexer umgeschaltet wird.

15. Energiezähler nach Anspruch 1, **dadurch gekennzeichnet, dass** die Unterschale (U) einen Zwischenboden (UZB) enthält, der aus dem durch die Unterschale (U) und die Abdeckung (SA) gebildeten geschützten Bereich (GR1) einen geschützten Teilbereich (GR1b) abgrenzt zur Anbringung mindestens eines weiteren externen Options-/Nachrüstmoduls (EO) und dass der Zwischenboden (UZB) entsprechende Aussparungen für mindestens eine externe Schnittstelle (OSE) zu mindestens einem im geschützten Teilbereich (GR1b) angebrachten externen Optionsmodul (EO) enthält.

## Claims

1. A meter, in particular energy meter (EZ) in modular construction, comprising:
• a two-part housing (SA, U) with a cover (SAK) or a housing hood (SA) and a lower shell (U) and with a releasable connection to the cohesion of the housing parts,
• at least one internal module (Z, K, IO, IR) arranged in a protected area,
• at least one external module (EO, ER, EK, EKR) arranged outside the protected area and
• at least one optical interface (OSE, OSI) arranged in the internal module (Z, K, IO, IR) and / or external module (EO, ER, EC, EKR), which is used for communication between the internal module (Z, K, IO, IR) and the external module (EO, ER, EK, EKR) including the recognition of the opening of the protected area.

2. The energy meter according to claim 1, **characterized in that** disposed in the protected area as internal modules are arranged a counter module (Z) and a terminal module (K), wherein the terminal module (K) comprising a terminal block (K1a, K1b; K2a, K2b; ..) for the mains connection (L1, L2, L3, N), for connecting the power supply (SM, SW) to the internal and / or external modules (IO, IR EO, ER, EKR) and for connecting at least a shunt (S), a transducer or a Rogowski coil and that the terminal module (K) having a separate lid (SAK).

3. The energy meter according to claim 2, **characterized in that** disposed in the protected area as an internal module are arranged an option module or a retrofit module connected via the optical interface (OSI) for communicating connection of the counter (EZ) by bidirectional data communication, in particular remote reading of encrypted data via the terminal module (K) arranged in the power supply to a central station, that for a bidirectional data communication with an external option / retrofit module, the internal option module (IO) having a further optical interface (OSE) and that said internal option module (IO) and / or said external option module (EO) are used for the bidirectional data transmission via a wired or a wireless network.

4. The energy meter according to claim 2 or 3, **characterized in that** disposed in the protected area as another internal module an internal relay module (IR) connected to the terminal module (K) is arranged, said relay module (IR) having at least a bistable relay (BI) controlled from the internal option module (IO) and said relay module (IR) is used for the separation of the end user from the mains connection (L1, L2, L3, N) or for the disconnection of individual phases (L1).

5. The energy meter according to claim 2, **characterized in that** the counter module (Z) has a transformer (Ü) whose primary side is connected to the terminal module (K) and the secondary side is connected both with a control device (CPU) of the counter module (Z) for evaluation, identification and displaying of the measurement signals supplied as well with voltage transformers (SW, SM) arranged in internal or external modules (IO, IR, EO, ER, EKR) or that a relay coil disposed in the terminal and relay module (EKR) serve at the same time as a transformer for the power supply (SW) for said option module disposed in the terminal and relay module (EKR).

6. The energy meter according to claim 2, **characterized in that** for the subsequent extension of the counter (EZ) an external relay module (ER) is mounted on the terminal block (K1a, K2b; K2a, K2b; ..) and that the external relay module (ER) has a communication / option module with optical connection (OSE) of the counter or an internal option module (Z, IO).

7. The energy meter according to claim 2, **characterized in that** disposed in a clamping cover (A) designed as housing cover a terminal and expansion module (EO) as an external option retrofit module with optical connection (OSE) of the counter or an internal option / retrofit module (Z, 10) or a reflector (R) is arranged and that the reflector (R) is designed as a prism.

8. The energy meter according to claim 7, **characterized in that** the customer number or meter point is stored in a memory of an external option module (EO) integrated in the housing designed as a hood terminal cover (A, AK), that disposed in the clamping cover (A, AK) an additional cover (AEO) is mounted such for the external option module (EO) a further protected area (GR3b) is formed and that the housing structure is formed such that the cover (SAK) of the terminal module by both the housing hood (SA) as well as by the clamping lid (A, AK) is locked.

9. The energy meter according to claim 2, **characterized in that** that the two-part housing (SA, U) having arranged on the end faces of the side walls a surrounding channel (UK), that the surrounding channel (UK) continues in the cover (SAK), that the two-part housing (SA, U) having arranged on the end faces of the side walls a surrounding a seal and said surrounding seal arranged on the end faces of the side walls is configured as an antenna in the ISM band 2.

10. The energy meter according to claim 5, **characterized in that** to protect the power supply of the control device (CPU) of the counter module (Z) and / or of an internal option module (Z, 10) on the secondary side of the transformer (U) or subsequent in the power supply paths, at least a fuse (S1, S2) is arranged and / or to protect downstream circuit parts of the energy meter (EZ) on the primary side of the transformer (Ü), at least a thermal fuse (S3) is arranged.

11. The energy meter according to claim 5, **characterized in that** the terminal block consisting of individual terminals (K1a, K1b; K2a, K2b; ..), supports (AKL; AK2; .., AAZ) for the individual terminals (K1a, K1b; K2a, K2b ; ..) and the shunt (S), resting on shunt (S) connecting tongues (AZ) and attachable to it and / or to the respective single terminal (K1a, K1b; K2a, K2b; ..) terminal springs (AF).

12. The energy meter according to claim 1, **characterized in that** the housing cover (SA) having a viewing window that via light guide fixed to the window the light from LEDs arranged on a circuit board (LP) in the lower shell (U) is emitted, and that via further light guides attached to the window a D0-interface (D0) for counter (remote) -reading and for outputting measured energy values or counts is formed.

13. The energy meter according to claim 2, **characterized in that** the lower shell (U) having integrally formed partition walls (T1a, T1b; T2a, T2b; ..) between each terminal (K1a, K1b; K2a, K2b; ..) which serve as guides for the lid (SAK), which is L-shape designed and having screw openings (SO), so that if the cover (SAK) is latched in the lower shell (U), respectively a closed chamber (GR2) for the respective terminal pair (K1a, K1b; K2a, K2b; ..) is formed, which is delimited through a leg (SSAK) relative to the counter module (Z), that the shunt (S) is arranged standing on the support (AK1; AK2; ..) and is guided through the partition (T1a, T2a, ..) and that the cover (SAK) of the terminal module (K) having recesses, which allow access from the protected area (GR3) to the terminals (K1b, K2b, ...).

14. The energy meter according to claim 1, **characterized in that** the connection of the optical interface (OSE) to one of the internal modules (Z, K, IO, IR) is carried out by changing a connecting cable between the internal modules or that the connection of the optical interface (OSE) to one of the internal modules (Z, K, IO, IR) is switched by an electronic multiplexer.

15. The energy meter according to claim 1, **characterized in that** that the lower shell (U) having an intermediate bottom (UZB), which compose a partial protected portion (GR1b) of the protected area (GR1), said is formed by the lower shell (U) and the cover (SA), and defining for mounting at least one further external option / retrofit module (EO) and that the intermediate base (UZB) having corresponding recesses for at least one external interface (OSE) to at least one external option module (EO) arranged in the protected portion (GR1b)

## Revendications

1. Un dispositif de mesure, en particulier compteur d'énergie modulaire (EZ), comprenant:
• un boîtier en deux parties (SA, U) avec un couvercle séparé (SAK) ou un couvercle du boîtier (SA) et une coque inférieure du boîtier (U) et avec une connexion détachable pour la cohésion des parties de boîtier,
• au moins un module interne (Z, K, IO, IR) disposé dans une zone protégée,
• au moins un module externe (EO, ER, EK, EKR) disposé en dehors de la zone protégée et
• au moins un dans le module interne (Z, K, 10, IR) et / ou un module externe (EO, ER, EK, EKR) est disposé une interface optique (OSE, OSI), qui est utilisée pour la communication entre le module interne (Z, K, IO, IR) and le module externe (EO, ER, EK, EKR), y compris la détection de l'ouverture de la zone protégée.

2. Compteur d'énergie selon la revendication 1, **caractérisé en ce que** dans la zone protégée en tant que modules internes, un module compteur (Z) et un module terminal (K) sont disposés, le module terminal (K) à un bornier (K1a, K1b; K2a, K2b; ..) pour une connexion réseau (L1, L2, L3, N), pour connecter l'alimentation (SM, SW) des modules internes et / ou externes (IO, IR, EO, ER, EKR) et pour connecter au moins un shunt (S), un transducteur ou une bobine de Rogowski et **en ce que** le module terminal (K) comporte un couvercle séparé (SAK).

3. Compteur d'énergie selon la revendication 2, **caractérisé en ce que** dans la zone protégée comme un module interne est un module options-/ retrofit (10), connecter avec le module compteur (Z) via la interface optique (OSI), pour la communication du compteur (EZ) en la communication de données bidirectionnelle, notamment la lecture à distance de données cryptées est fourni via le module terminal (K) et le réseau électrique (L2, L2, L3, N) à un bureau central, **en ce que** pour la transmission de données bidirectionnelle avec un module option / retrofit externe, le module d'option interne (IO) comporte une autre interface optique (OSE) et **en ce que** le module d'option interne (IO) et / ou le module d'option externe (EO) servent à la transmission de données bidirectionnelle via un réseau filaire ou sans fil.

4. Compteur d'énergie selon la revendication 2 ou 3, **caractérisé en ce que** dans la zone protégée, comme un autre module interne, un module relais interne (IR) est disposé et connecté avec le module terminal (K), qui comprend au moins un relais bistable (BI) commandé par le module d'option interne (IO) et qui est utilisé pour séparer le client final du réseau (L1, L2, L3, N) ou pour couper les phases individuelles (L1).

5. Compteur d'énergie selon la revendication 2, **caractérisé en ce que** le module compteur (Z) comporte un transformateur (Ü) dont le côté primaire est connectés avec le module terminal (K) et son côté secondaire est connectés tant avec un dispositif de commande (CPU) du module compteur (Z) pour évaluation, identification et affichage les signaux de mesure fournis ainsi que est connectés avec les transformateurs de tension (SW, SM) intégrés aux modules internes ou externes (IO, IR EO, ER, EKR) et **en ce qu'**une bobine de relais dans le module terminal et relais (EKR) sert simultanément comme transformateur pour l'alimentation (SW) du module optionnel contenu dans le module terminal et relais (EKR).

6. Compteur d'énergie selon la revendication 2, **caractérisé en ce que** pour l'extension subséquente du compteur (EZ) est monté un module de relais externe (ER) sur le bornier (K1a, K1b; K2a, K2b; ..) et **en ce que** le module de relais externe (ER) comporte un module de communication / option avec connexion optique (OSE) au module de compteur ou un module d'option interne (Z, IO).

7. Compteur d'énergie selon la revendication 2, **caractérisé en ce qu'**un couvercle des bornes (A) conçue comme un couvercle du boîtier, un module de terminal et d'extension (EO) en tant que module d'adaptation d'option externe avec connexion optique (OSE) est disposé au module de compteur ou au module d'option interne (Z, IO) ou au réflecteur (R) et **en ce que** le réflecteur (R) est conçu comme un prisme.

8. Compteur d'énergie selon la revendication 7, **caractérisé en ce qu'**le numéro de client ou la description du point de comptage est stockée dans une mémoire du couvercle du boîtier conçue comme un module d'option externe (EO) intégré au couvercle des bornes (A, AK), **en ce que** dans le couvercle des bornes (A, AK) un couvercle supplémentaire (AEO) est monté de sorte que pour le module d'option externe (EO), une autre zone protégée (GR3b) est formée et **en ce que** la construction du boîtier est conçue de telle sorte que le couvercle (SAK) du module terminal est verrouillé à la fois par le couvercle du boîtier (SA) et par le couvercle des bornes (A, AK).

9. Compteur d'énergie selon la revendication 1, **caractérisé en ce que** le boîtier en deux parties (SA, U) comporte sur les faces frontales d'un canal circonférentiel (UK), **en ce que** le canal circonférentiel (UK) continue dans la couverture (SAK), **en ce que** le boîtier en deux parties (SA, U) comporte sur les faces frontales des parois latérales un joint circonférentiel et **en ce que** sur les faces d'extrémité des parois latérales, le joint circonférentiel est conçu comme une antenne dans la bande ISM 2.

10. Compteur d'énergie selon la revendication 5, **caractérisé en ce que** pour protéger l'alimentation du dispositif de commande (CPU) du module compteur (Z) et / ou d'un module optionnel interne (Z, IO), sur le côté secondaire du transformateur (U) au moins un fusible (S1, S2) est arrangé et / ou **en ce que** pour la protection des parties de circuit subséquentes du compteur d'énergie (EZ) sur le côté primaire du transformateur (Ü), au moins un fusible thermique (S3) est disposé.

11. Compteur d'énergie selon la revendication 2, **caractérisé en ce que** le bornier se composent des bornes individuelles (K1a, K1b; K2a, K2b; ..), des appuis (AK1, AK2, .., AAZ) pour les bornes individuelles (K1a, K1b; K2a, K2b;..) et le shunt (S), sur celui supporté des pattes terminales sus-jacentes (AZ) et sur celles-ci et / ou sur les bornes individuelles respectives (K1a, K1b, K2a, K2b, ..) de ressorts de connexion (AF).

12. Compteur d'énergie selon la revendication 1, **caractérisé en ce que** le couvercle de boîtier (SA) comporte une fenêtre de visualisation, **en ce que** via un guide de lumière fixée sur fenêtre, la lumière est diffusée par **la diode électroluminescente** monté sur une carte de circuit imprimé celui-ci disposé de la coque inférieure du boîtier (U) et **en ce que** le guide de lumière monté sur la fenêtre d'inspection une interface DO (DO) pour la lecture du compteur (à distance) et pour délivrer des lectures d'énergie ou des comptages est conçu.

13. Compteur d'énergie selon la revendication 2, **caractérisé en ce que** la coque inférieure (U) forme des cloisons formées intégralement (T1a, T1b; T2a, T2b; ..) entre les bornes individuelles (K1a, K1b, K2a, K2b; ..), qui servent comme des guides pour la couvercle (SAK) celui-ci est en forme de L et ayant des ouvertures de vis (SÖ), de sorte que dans la coquille inférieure (U) le couvercle (SAK) est encliqueté, par la jambe (SSAK) et par rapport à du module compteur (Z) la chambre (GR2) est formée pour la paire de bornes respective (K1a, K1b, K2a, K2b; ..) et **en ce que** le shunt (S) se trouvant sur le support (AK1; AK2; ..) disposé et à travers la cloison (T1a, T2a, ..) est guidé et **en ce que** le couvercle (SAK) du module terminal (K) présente des évidements qui permettent l'accès aux bornes (K1b, K2b, ...) de la zone protégée (GR3).

14. Compteur d'énergie selon la revendication 1, **caractérisé en ce que** la connexion de l'interface optique (OSE) à l'un des modules internes (Z, K, IO, IR) se fait en branchant un câble de liaison entre les modules internes ou **en ce que** la connexion de l'interface optique (OSE) à l'un des modules internes (Z, K, IO, IR) est commutée par un multiplexeur électronique.

15. Compteur d'énergie selon la revendication 1, **caractérisé en ce que** la coque inférieure (U) contient un plancher intermédiaire (UZB), qui délimite une zone partielle protégée (GR1b) de la zone protégée (GR1), formée par la coque inférieure (U) et par la couverture (SA), pour fixation d'au moins un module option / retrofit externe supplémentaire (EO) et **en ce que** le plancher intermédiaire (UZB) contient des évidements correspondants pour au moins une interface externe (OSE) à au moins un module d'option externe (EO) monté dans la sous-zone protégée (GR1b).
